# EUROPÄISCHE PATENTSCHRIFT

(11) **EP 0 837 334 B1**
(45) Veröffentlichungstag und Bekanntmachung des Hinweises auf die Patenterteilung: **05.03.2008**
(21) Anmeldenummer: 97117732.4
(22) Anmeldetag: 14.10.1997
(51) Int. Cl.: G01R 29/08

(54) **Verfahren und Vorrichtung zur Bestimmung einfallender Empfangsleistung oder -energie wenigstens eines Signales**
Procedure and apparatus for determining incident receiver power or energy of at least one signal
Procédé et appareil pour déterminer la puissance ou l'énergie incident d'au moins un signal

(30) Priorität: 16.10.1996 DE 19642630
(43) Veröffentlichungstag der Anmeldung: 22.04.1998
(73) Patentinhaber: Grassmann, Edgar, 31234 Edemissen (DE)
(72) Erfinder: Grassmann, Edgar, 31234 Edemissen (DE)
(74) Vertreter: Wagner, Carsten

(56) Entgegenhaltungen:
- EP-A- 0 395 863
- EP-A- 0 473 281
- US-A- 5 053 781
- FENN A J: "ANALYSIS OF PHASE-FOCUSED NEAR-FIELD TESTING FOR MULTIPHASE-CENTER ADAPTIVE RADAR SYSTEMS" IEEE TRANSACTIONS ON ANTENNAS AND PROPAGATION, Bd. 40, Nr. 8, 1. August 1992 (1992-08-01), Seiten 878-887, XP000307048 ISSN: 0018-926X

## Beschreibung

Die Erfindung betrifft ein Verfahren und eine Vorrichtung zur Bestimmung einfallender Empfangsleistung oder -energie oder anderer technischer Meßgrößen wenigstens eines Signales in wenigstens einer vorgebbaren Beobachtungsrichtung sowie eine Empfangsanlage.

Es sind Verfahren zur Bestimmung einfallender Empfangsleistung oder -energie bekannt, bei denen Antennenanordnungen verwendet werden, mittels derer aufgrund der Antennengeometrie und anderer Maßnahmen wenigstens zwei oder aber mehrere asymmetrische, richtungs- und lagebestimmte Strahlungsdiagramme erzeugbar sind. Die Strahlungsdiagramme können konusförmig oder fächerförmig sein; sie werden auch als Strahlungsfächer bezeichnet. Die Strahlungsdiagramme können sich bei dem bekannten Verfahren in vorgebbarer Anzahl und Weise mit beliebiger räumlicher Verteilung in Schnittgebieten gegenseitig durchdringen.

Mit dem Begriff "Schnittgebiet" soll das diagrammäßige Kollektiv derjenigen Strahlungsdiagramme bzw. Strahlungsfächer bezeichnet werden, deren gegenseitige Durchdringung vornehmlich, aber nicht notwendigerweise ausschließlich, in einer bestimmten Hauptstrahlrichtung festgelegt ist. Auf diese Weise werden bei dem bekannten Verfahren synthetisch höher bündelnde Strahlungsdiagramme erzeugt, und zwar mit sogenannten nicht gefüllten Aperturen. Derartige nicht gefüllte Aperturen (vgl. hierzu "Interferometry and Synthesis in Radioastronomy", A. Richard Thompson, James M. Moran, George W. Swenson, Seite 118 ff., Krieger Publishing Company, 1991 sowie "The Synthesis of large Radio Telescopes", M. Ryle, A. Hewish, in: Instrumentation and Techniques for Radio Astronomy, Seite 97) sind vornehmlich auch dadurch gekennzeichnet, daß sie mehrere Einzelsensoren, beispielsweise Antennen, aufweisen, aus deren Ausgangssignal mit bekannten Strahlformungsmitteln bzw. Strahlformungsverfahren die fächer- oder konusförmigen Strahlungsdiagramme erzeugt werden. Es ist deshalb mit nicht gefüllten Aperturen möglich, aus den Ausgangssignalen der Einzelsensoren eine beliebig vorgebbare Anzahl von Strahlungsdiagrammen gleichzeitig zu erzeugen.

Ein Beispiel eines Strahlformungsmittels, das gleichzeitig eine bestimmte Anzahl richtungsbestimmter Strahlungsdiagramme (Strahlungsfächer) aus den Ausgangssignalen einer Zeile von Einzelsensoren erzeugt, ist eine Butler-Matrix (vgl. beispielsweise "Antenna Engineering Handbook", Richard C. Johnson, Kapitel 20-56, Mc. Graw Hill Inc., 1992), die mit analogen Mitteln die Funktion einer Fourier-Transformation (FFT) nachbildet. Die Strahlungsdiagramme, beispielsweise Strahlungsfächer, können jedoch auch durch andere Strahlformungsmittel (vgl. beispielsweise "Computational Methods Of Signal Recovery And Recognition", Richard J. Mammone, Seite 272 ff., John Wiley & Sons Inc., 1992) erzeugt werden, beispielsweise durch ein Phasennetzwerk.

Zu den nicht gefüllten Aperturen zählen auch solche, die es ermöglichen, daß sich verschiedene fächer- oder konusförmige Strahlungsdiagramme in lokalisierbaren Diagrammgebieten gegenseitig durchdringen. Beispiele hierfür sind winklig zueinander angeordnete Antennenzeilen. Eine der vielen möglichen Anordnungen ist als sog. "Mills-Cross" bekannt, bei dem zwei Dipolzeilen orthogonal, beispielsweise in Kreuz- oder L-Form, zueinander stehen. Mit derartigen Antennen- und Sensoranordnungen mit nicht gefüllter Apertur sind asymmetrische, fächer- oder konusförmige Strahlungsdiagramme erzeugbar, die vornehmlich in einer Ebene stärker bündelnd sind als in einer anderen Ebene.

Rotationssymmetrische oder mehr oder weniger in allen Ebenen gleich bündelnde Strahlungsdiagramme sind auf direktem Weg nur mit gefüllten Aperturen erzeugbar, bei denen der Aufwand und die Kosten jedoch um ein mehrfaches höher sind als bei nicht gefüllten Aperturen. Ein Beispiel für eine gefüllte Apertur ist die Fläche eines Parabolspiegels. Ein Beispiel für eine nicht gefüllte Apertur ist ein Dipolzeile.

Bei dem bekannten Verfahren wird aus den jeweils ein Schnittgebiet bildenden Strahlungsfächern mittels einer analogen oder digitalen Apparatur durch Korrelation ein neues Strahlungsdiagramm erzeugt. Da ein aus Richtung des Schnittpunktes oder Schnittgebietes kommendes Signal gleichzeitig gemeinsames Element der sich schneidenden Strahlungdiagramme ist, ergibt sich im Schnittpunkt ein Korrelationsergebnis in Gestalt einer Antennenkeule, die insgesamt schmaler und mehr geformt ist als die Strahlungsfächer bzw. Strahlungsdiagramme, die das Schnittgebiet bilden.

Wird beispielsweise bei dem bekannten Verfahren die Sensoranordnung durch ein aus zwei Dipolzeilen bestehendes Mills-Cross gebildet, so kann mittels der oben erwähnten Butler-Matrizen eine vorgebbare Anzahl orthogonal zueinander stehender Strahlungsfächer erzeugt werden, die in allen gewünschten Kombinationen in ihren Schnittgebieten gegeneinander korreliert werden können.

Ein Nachteil des bekannten Verfahrens besteht darin, daß andere, nicht aus Richtung des Schnittgebietes über einen Strahlungsfächer einfallende Stör- oder Signalquellen das in Richtung des Schnittgebiets gewonnene Meßergebnis unabhängig von der synthetischen Diagrammbildung verfälschen. Insbesondere bei gleichzeitiger räumlicher Verteilung eines gesamten Ensembles der von den Strahlungsfächern gebildeten Schnittgebiete geht bei Störungen die Eindeutigkeit des Meßergebnisses völlig verloren.

Bei dem bekannten Verfahren wird durch die Korrelation ein Strahlungsdiagramm gebildet, das im Idealfall nur Signale aus Richtung des gemeinsamen Schnittgebiets aufnimmt. Jedoch unterscheidet sich die Korrelation von solchen Verfahren, die die Signalspannung der Einzelsensoren, beispielsweise in einem analogen Netzwerk, nach Phase und Amplitude vektoriell zusammenführen. Ein im Fächerdiagramm liegender, aber nicht aus Hauptstrahlrichtung einfallender massiver Rauschstörer liefert - ohne durch den Korrelationsvorgang regelmäßig reduziert zu werden - eine entsprechende Empfangsleistung in die Auswerteeinheit des betroffenen Strahlungsfächers. Dies hat zur Folge, daß ein aus Hauptstrahlrichtung einfallendes Nutzsignal im betroffenen Fächerkanal unter einem höheren Empfänger-Rauschpegel zu verarbeiten ist als ohne Rauschstörer. Da das Nutzsignal mit Störer tiefer im Rauschen verborgen ist als ohne Störer, ist ersichtlich, daß aus beiden Fällen auch entsprechend unterschiedliche Korrelationsergebnisse resultieren. Der Unterschied in den Korrelationsergebnissen ändert nicht die Form der Korrelationsfunktion bzw. des synthetischen Strahlungsdiagramms, sondern nur den Wert der Korrelation.

Nimmt man beispielsweise an, daß ein Rauschstörer in gepulster Weise auftritt und das Nutzsignal aus Hauptstrahlrichtung ebenfalls durch ein gepulstes Rauschsignal gebildet ist, dann kann bei dem bekannten Verfahren die Korrelation nicht mehr eindeutig zwischen Pulstakt und zugehöriger Quelle unterscheiden. Ist der Störer der einen Hauptstrahlrichtung gleichzeitig Nutzsignal in einer anderen Richtung eines gemeinsamen Fächers, dann können die Signale bei dem bekannten Verfahren über die Korrelation voneinander nicht mehr eindeutig unterschieden werden. Daraus ergibt sich, daß die Empfangsleistung oder energie in einer zu messenden Hauptstrahlrichtung ebenfalls nicht mehr eindeutig auswertbar ist. In Anordnungen, die eine größere Anzahl von sich gegenseitig schneidenden Strahlungsfächern aufweisen, geht somit die Eindeutigkeit des Meßergebnisses vollends verloren.

Ein weiterer Nachteil des bekannten Verfahrens besteht somit darin, daß im Aufnahmesystem nur eine einzige Signalquelle innerhalb einer gegebenen Frequenzbandbreite auftreten darf oder der Signalpegel zumindest groß gegenüber anderen Signalen sein muß (vgl. hierzu "Radio Astronomy", John D. Kraus, Kapitel 6-25, Cygnus Quasar Bools, 1986).

Daraus ergibt sich der weitere Nachteil, daß die gleichzeitige, eindeutige Bestimmung der Empfangsleistung von Signalen, die sich nur durch ihre Einfallsrichtung unterscheiden, innerhalb einer gegebenen Frequenzbandbreite mit dem bekannten Verfahren mit Sensoren mit nicht gefüllter Apertur nicht möglich ist.

US 5 053 781 offenbart Empfangsanlagen mit Sensoranordnungen in Kreuzform.

Die Aufgabe der vorliegenden Erfindung besteht darin, ein Verfahren und eine Vorrichtung anzugeben, bei der die einfallende Empfangsleistung oder -energie eines Signales in einer vorgebbaren Beobachtungsrichtung auch unter Einwirkung anderer Signale aus anderen Richtungen mit höherer Genauigkeit bestimmbar ist.

Diese Aufgabe wird hinsichtlich des Verfahrens durch die im Anspruch 1 angegebene Lehre und hinsichtlich der Vorrichtung durch die im Anspruch 31 angegebene Lehre gelöst, sowie mit einer Empfangsanlage nach dem Anspruch 48.

Die Erfindung geht von der Erkenntnis aus, daß dann, wenn mehrere Signale aus unterschiedlichen Richtungen gleichzeitig in eine Sensoranordnung einfallen, ein Nutzsignal zu einer bestimmten Richtung innerhalb eines Strahlungsfächers gleichzeitig Störsignal zu einer anderen Richtung innerhalb desselben Fächers sein kann und daß daher die Messung einer in einer Beobachtungsrichtung einfallenden Empfangsleistung in Abhängigkeit zu der Leistung von in anderen Richtungen einfallenden Signalen steht.

Die Erfindung geht weiter von der Erkenntnis aus, daß daher die in einer bestimmten Beobachtungsrichtung einfallende Leistung nicht auf direktem Wege ermittelbar ist.

Der Grundgedanke der erfindungsgemäßen Lehre besteht darin, beispielsweise bei der Betrachtung eines Schnittgebietes, das durch zwei Strahlungsfächer gebildet wird, nicht nur von der allein dem Schnittgebiet zugeordneten Empfangsleistung auszugehen, sondern von der gesamten, von den an der Bildung des Schnittgebietes beteiligten Strahlungsfächern aufgenommenen Leistung.

Der weitere Gedanke der Erfindung besteht nun darin, aus einer vorgegebenen Anzahl von Strahlungsfächern einen sogenannten Hauptsignalraum zu bilden.

Unter einem Signalraum (vgl. hierzu auch "Advanced Signal Processing and Digital Noise Reduction", Saeed V. Vaseghi, Seite 4 ff., Seite 20 ff., Wiley & Sons Inc., 1996; sowie "Computational Methods Of Signal Recovery And Recognition", Richard J. Mammone, Seite 13, John Wiley & Sons Inc., 1992) soll hierbei eine Gruppe von Signalen verstanden werden.

Erfindungsgemäß wird zunächst eine Anzahl von Strahlungsfächern gebildet ausgewählt und ausgehend von diesen Strahlungsfächern ein Hauptsignalraum gebildet, der die Form der Strahlungsfächer und die diesen Fächern zugeordnete Empfangsleistung oder -energie repräsentiert. Geht man beispielsweise von einer Sensoranordnung mit zwei Sensorzeilen aus, aus deren einer Sensorzeile zwei Strahlungsfächer gebildet werden, so kann die Berandungskurve des Hauptsignalraumes durch eine vektorielle Summation der Berandungskurven der beiden Strahlungsfächer gebildet werden, wobei der Hauptsignalraum dann gleichzeitig diejenige Empfangsleistung oder -energie repräsentiert, die den beiden Strahlungsfächern zugeordnet ist.

Ausgehend von diesem Hauptsignalraum wird erfindungsgemäß ein Maß für den Anteil jedes an der Bildung eines Schnittgebietes beteiligten Strahlungsfächers an der dem Hauptsignal zugeordneten Gesamt-Empfangsleistung oder -energie bestimmt.

Ist dieses Maß für jeden an der Bildung eines bestimmten Schnittgebiet beteiligten Fächers bekannt, so wird ein Maß für den diesem Schnittgebiet zugeordneten Anteil an der Empfangsleistung oder -energie, die den Strahlungsfächern, die dieses Schnittgebiet bilden, zugeordnet ist, bestimmt.

Die auf diese Weise bestimmten Maße bilden Zwischenergebnisse, durch deren Verknüpfung bestimmt wird, welchen Teil das betrachtete Schnittgebiet und damit eine vorgegebene Beobachtungsrichtung zur Gesamt-Empfangsleistung oder -energie des Hauptsignalraumes beiträgt. Auf diese Weise läßt sich die Empfangsleistung oder -energie zu jedem Schnittgebiet und damit zu einer vorgebbaren Beobachtungsrichtung im wesentlichen konfusionsfrei, d.h. im wesentlichen frei von Mehrdeutigkeiten, die von aus anderen Richtungen einfallenden Signalen herrühren können, bestimmen.

Da somit bei Messungen in einer vorgegebenen Beobachtungsrichtung Signale, die aus anderen Richtungen einfallen, aufgrund des erfindungsgemäßen Verfahrens das Meßergebnis nicht beeinflussen, die Messung in einer bestimmten Beobachtungsrichtung somit jeweils konfusionsfrei erfolgt, ermöglicht es das erfindungsgemäße Verfahren, gleichzeitig in mehreren, beliebig vorgebbaren Beobachtungsrichtungen die jeweils einfallende Empfangsleistung bzw. -energie zu bestimmen.

Hierbei erfolgt die Auswahl einer gewünschten Beobachtungsrichtung (Meßrichtung) in der Regel durch Auswahl von Schnittgebieten.

Somit ermöglicht das erfindungsgemäße Verfahren die gleichzeitige Auswertung der Empfangsleistung oder energie auch von gleichkanaligen Signalen, die sich lediglich durch die Einfallsrichtung unterscheiden. Ein Störsignal zu einer Beobachtungsrichtung kann somit gleichzeitig Nutzsignal zu einer anderen Beobachtungsrichtung sein, ohne daß hierdurch die Meßergebnisse in unterschiedlichen Beobachtungsrichtungen negativ beeinflußt werden.

Ein weiterer Vorteil des erfindungsgemäßen Verfahrens besteht darin, daß eine eindeutige Bestimmung der Empfangsleistung oder -energie auch mittels einer Sensor- oder Antennenanordnung mit nicht gefüllter Apertur möglich ist. Kostenaufwendige Sensor- oder Antennenanordnungen mit gefüllter Apertur sind somit grundsätzlich nicht erforderlich, so daß der apparative Aufwand zur Durchführung des erfindungsgemäßen Verfahrens verringert ist.

Ein weiterer Vorteil des erfindungsgemäßen Verfahrens besteht darin, daß sich sehr hohe Verarbeitunggeschwindigkeiten und damit eine hohe Effizienz erzielen lassen, da die zu verarbeitenden Signale nicht in maximaler Bitwertiger Auflösung quantisiert zu werden brauchen, um die gewünschte Auflösung des aufgenommen Empfangsleistungs- oder Energiepegels zu erzielen. Da das erfindungsgemäße Verfahren auf der Bildung von relativen Maßen, beispielsweise Wahrscheinlichkeitsmaßen, basiert, ist lediglich eine reduzierte Quantisierung bis hin zu einer 1-Bit-wertigen Quantisierung (Two Level Quantization) erforderlich. Anhand dieser relativen Maße läßt sich dann aus einem einmal pro Meßgang, beispielsweise für den Hauptsignalraum, gemessenen absoluten Wert der Gesamt-Empfangsleistung oder -energie die den einzelnen Beobachtungsrichtungen (Meßrichtungen) zugeordneten absoluten Werte der Empfangsleitung oder - energie bestimmen.

Die unterschiedlichen Verfahrensschritte des erfindungsgemäßen Verfahrens können parallel zueinander ausgeführt werden, was die Verarbeitungsgeschwindigkeit weiter erhöht.

Zur Bildung von Strahlungsfächern aus den Ausgangssignalen von einzelnen Sensoren oder Sensorbereichen, insbesondere aber aus den Ausgangssignalen von Gruppen von Sensoren, sind beliebige, dem Fachmann allgemein bekannte Strahlformungsmittel verwendbar.

Erfindungsgemäß wird unter der Bestimmung von Empfangsleistung oder -energie auch die Bestimmung anderer, mit der Empfangsleistung oder -energie in Zusammenhang stehender Meßgrößen eines Empfangssignales verstanden. Beispielsweise können Empfangsspannungen oder komplexwertige Modulationssignale im Zeitbereich ausgewertet werden.

Grundsätzlich ist es ausreichend, wenn die Strahlungsfächer ein Schnittgebiet bilden. Eine Weiterbildung der erfindungsgemäßen Lehre sieht jedoch vor, daß die Strahlungsfächer wenigstens zwei, vorzugsweise mehr als zwei Schnittgebiete bilden, derart, daß unterschiedliche Beobachtungsrichtungen durch Auswahl unterschiedlicher Schnittgebiete wählbar sind. Bei dieser Ausführungsform ist eine gewünschte Beobachtungsrichtung durch Auswahl entsprechender Schnittgebiete wählbar.

Zur Bestimmung der in einer gewünschten Beobachtungsrichtung einfallenden Empfangsleistung oder -energie ist es grundsätzlich ausreichend, wenn zwei Strahlungsfächer ein Schnittgebiet bilden. Eine besonders vorteilhafte Ausführungsform sieht jedoch vor, daß wenigstens drei Strahlungsfächer ein räumliches Schnittgebiet bilden, das ein Beobachtungsgebiet bildet, derart, daß die aus dem Beobachtungsgebiet herrührende Empfangsleistung oder -energie bestimmbar ist. Bei dieser Ausführungsform ist somit nicht nur die aus einer bestimmten Beobachtungsrichtung herrührende Empfangsleistung oder -energie, sondern die aus einem räumlich begrenzten und damit lokalisierbaren Beobachtungsgebiet herrührende Empfangsleistung oder -energie bestimmbar. Befindet sich beispielsweise in einem Beobachtungsgebiet, das durch entsprechende Auswahl von Schnittgebieten bzw. Strahlungsfächern ausgewählt ist, ein Objekt, von dem eine Empfangsleistung oder -energie herrührt, beispielsweise durch ein von diesem Objekt aktiv oder passiv emittiertes Signal, so ist die Anwesenheit des Objektes in dem ausgewählten Beobachtungsgebiet feststellbar und damit das Objekt lokalisierbar.

Eine andere Weiterbildung der erfindungsgemäßen Lehre sieht vor, daß gleichzeitig in wenigstens zwei Beobachtungsrichtungen und/oder für wenigstens zwei Beobachtungsgebiete die einfallende Empfangsleistung - oder -energie bestimmt wird. Auf diese Weise kann gleichzeitig in mehreren Beobachtungsrichtungen gemessen werden, was dadurch möglich ist, daß in Bezug auf eine Beobachtungsrichtung oder ein Beobachtungsgebiet die Bestimmung der Empfangsleistung oder -energie durch aus anderen Beobachtungsrichtungen bzw. Beobachtungsgebieten herrührende Empfangsleistungen oder -energien nicht gestört wird, die Bestimmung der Empfangsleistung oder -energie also für jede Beobachtungsrichtung bzw. jedes Beobachtungsgebiet konfusionsfrei möglich ist.

Grundsätzlich ist es ausreichend, für eine gewünschte Beobachtungsrichtung oder ein gewünschtes Beobachtungsgebiet ein relatives Maß für die einfallende Empfangsleistung oder -energie zu bestimmen. Wird beispielsweise gleichzeitig in zwei Beobachtungsrichtungen gemessen, so ist es grundsätzlich ausreichend, für die Beobachtungsrichtungen jeweils ein relatives Maß für die einfallende Empfangsleistung oder -energie zu bestimmen, um eine Aussage darüber treffen zu können, in welchem Verhältnis die aus den beiden Beobachtungsrichtungen einfallenden Empfangsleistungen oder -energien relativ zueinander stehen. Eine besonders vorteilhafte Weiterbildung der erfindungsgemäßen Lehre sieht jedoch vor, daß die dem Hauptsignalraum zugeordnete Gesamt-Empfangsleistung oder -energie oder ein Maß für diese Gesamt-Empfangsleistung oder -energie bestimmt wird. Ist auf diese Weise der absolute Wert der dem Hauptsignalraum zugeordneten Gesamtleistung oder -energie bestimmt worden, was grundsätzlich nur einmal pro Meßgang erforderlich ist, so kann anhand dieses absoluten Wertes und dem relativen Anteil eines bestimmten Schnittgebietes und damit einer bestimmten Beobachtungsrichtung an der Gesamt-Empfangsleistung oder -energie der absolute Wert derjenigen Empfangsleistung oder -energie bestimmt werden, die dem jeweiligen Schnittgebiet und damit der jeweiligen Beobachtungsrichtung zugeordnet ist. Statt der dem Hauptsignalraum zugeordneten absoluten Empfangsleistung oder -energie kann auch die einem Strahlungsfächer zugeordnete Empfangsleistung oder -energie bestimmt werden; da es erfindungsgemäß möglich ist, für jeden Strahlungsfächer ein relatives Maß für seinen Anteil an der Gesamt-Empfangsleistung oder -energie zu bestimmen, sind aus der Kenntnis des absoluten Wertes der Empofangsleistung oder -energie für einen Strahlungsfächer sämtliche anderen absoluten Werte für die anderen Strahlungsfächer und Schnittgebiete skalierbar. Ist die über ein Schnittgebiet aufgenommene Leistung oder Energie von vorne herein bekannt, beispielsweise durch Vorgabe eines Meß-Sendesignales (Kalibrierungssignales) mit bekannter oder vorgebener Leistung oder -energie, so kann dieses Schnittgebiet zur Skalierung herangezogen werden.

Zweckmäßigerweise wird der Hauptsignalraum entsprechend der Form von Strahlungsfächern und der den Strahlungsfächern zugeordneten Empfangsleistung oder -energie durch einen Zusatzsensor erzeugt und/oder repräsentiert, oder der Hauptsignalraum wird durch vektorielle Summation von Strahlungsfächern gebildet.

Eine Weiterbildung der Ausführungsform, bei der drei Strahlungsfächer ein dreidimensionales Beobachtungsgebiet bilden, sieht vor, daß durch Bestimmung der aus dem Beobachtungsgebiet herrührenden Empfangsleistung oder -energie die Position eines Objektes im Raum festgestellt wird. So ist es beispielsweise möglich, durch zeitlich aufeinanderfolgende Beobachtung eines Beobachtungsgebietes festzustellen, wann sich ein Objekt in diesem Beobachtungsgebiet befindet. Es ist beispielsweise auch möglich, durch gleichzeitige Beobachtung mehrerer Beobachtungsgebiete festzustellen, zu welchem Zeitpunkt sich das Objekt in welchem der Beobachtungsgebiete befindet. Auf diese Weise ist es möglich, die Bewegung eines Objektes im dreidimensionalen Raum zu verfolgen und/oder ein oder mehrere Objekte im dreidimensionalen Raum zu orten, sofern von dem Objekt ein beliebiges Signal herrührt, dessen Empfangsleistung oder -energie bestimmbar ist. Das Signal kann hierbei beispielsweise ein von dem Objekt aktiv ausgesendetes Signal, beispielsweise ein Funksignal, sein. Das Signal kann jedoch beispielsweise auch ein von dem Objekt reflektiertes Signal sein, beispielsweise ein Radarsignal.

Eine andere Weiterbildung der erfindungsgemäßen Lehre sieht vor, daß durch aufeinanderfolgend unterschiedliche Wahl der Beobachtungsrichtung oder des Beobachtungsraumes oder durch gleichzeitige Wahl mehrerer Beobachtungsrichtungen oder Beoachtungsräume wenigstens ein Objekt wenigstens teilweise abgetastet wird. Auf diese Weise läßt sich die Energieverteilung, beispielsweise zweidimensional an der Oberfläche eines Objektes oder aber dreidimensional, bestimmen.

Eine Weiterbildung der vorgenannten Ausführungsform sieht vor, daß aus der durch Abtasten des Objektes bzw. der Objekte bestimmten Energie- oder Leistungsverteilung des Objektes bzw. der Objekte ein Abbild des Objekte bzw. des Objektes gebildet wird. Auf diese Weise ist das erfindungsgemäße Verfahren als bildgebendes Verfahren einsetzbar, wobei die gewünschte zweidimensionale, also flächige oder die dreidimensionale, also räumliche Auflösung in weiten-Grenzen wählbar ist. Auch hierbei ist es möglich von dem abzubildenden Objekt herrührende Empfangsleistung oder -energie eines beliebigen Signales zu bestimmen und auf diese Weise ein Abbild des Objektes zu bilden. Beispielsweise können die Sensormittel zur Erfassung von Wärmestrahlung ausgebildet sein, so daß die von der Wärmestrahlung des Objektes herrührende Empfangsleistung oder -energie bestimmt wird. Durch gleichzeitige oder aufeinanderfolgende Wahl entsprechender Beobachtungsrichtungen oder Beobachtungsgebiete ist dann die gewünschte Auflösung der Wärmestrahlungsverteilung des Objektes ermöglicht, so daß ein Abbild des Objektes gebildet werden kann.

Gemäß einer anderen Ausführungsform wird die Position wenigstens eines ortsfesten und/oder die Position wenigstens eines beweglichen Objektes festgestellt. Es ist somit die Ortung beliebiger ortsfester oder beweglicher Objekte oder von Gruppen von Objekten ermöglicht, beispielsweise von Fischschwärmen unter Wasser oder von Landfahrzeugen, Wasserfahrzeugen oder Luftfahrzeugen.

Gemäß einer anderen Ausführungsform wird durch aufeinanderfolgend unterschiedliche Wahl der Beobachtungsrichtung oder des Beobachtungsgebietes die Position eines beweglichen Objektes verfolgt.

Mit dem erfindungsgemäßen Verfahren sind beliebige Signale empfangbar, von denen in irgendeiner Weise eine Empfangsleistung oder -energie herrührt. Das Signal, dessen Empfangsleistung oder -energie bestimmt wird, kann zweckmäßigerweise ein radiometrisches oder von einem Objekt passiv und/oder aktiv emittiertes bwz. reflektiertes Signal sein. Die Empfangsleistung kann beispielsweise auch von radioaktiver Strahlung herrühren.

Eine andere Ausführungsform sieht vor, daß die Empfangsleistung oder -energie eines Signales als Maß für die Absorption dieses Signales durch ein sich in Beobachtungsrichtung oder im Beobachtungsgebiet befindendes Objekt bestimmt wird. Wird beispielsweise die Empfangsleistung einfallender radiometrischer Strahlung bestimmt, so wird dann, wenn sich ein Objekt in Beobachtungsrichtung oder in einem Beobachtungsgebiet befindet, die radiometrische Strahlung von diesem Objekt absorbiert. Durch die Absorption der radiometrischen Strahlung tritt eine Änderung der in Beobachtungsrichtung oder aus einem Beobachtungsgebiet einfallenden Empfangsleistung oder -energie ein. Auf diese Weise ist nicht nur feststellbar, daß sich ein Objekt in Beobachtungsrichtung oder einem Beobachtungsgebiet befindet, sondern auch, in welchem Maße und mit welcher Verteilung das Objekt die radiometrische Strahlung absorbiert.

Grundsätzlich können die bei dem erfindungsgemäßen Verfahren verwendeten Sensormittel eine gefüllte Apertur aufweisen, beispielsweise kann die gefüllte Apertur durch die Fläche eines Parabolspiegels gebildet sein. Zur Bildung der Strahlungsfächer können dann zeilenförmige Bereiche der gefüllten Apertur herangezogen werden. Beispielsweise können zur Erzeugung der Strahlungsfächer zwei orthogonal zueinander verlaufende zeilenförmige Bereiche der gefüllten Apertur herangezogen werden, die jeweils für sich dann die Eigenschaften einer nicht gefüllten Apertur aufweisen. Durch geeignete Strahlformungsmittel werden dann beispielsweise von dem ersten zeilenförmigen Bereich eine erste Gruppe von Strahlungsfächern und von dem zweiten zeilenförmigen Bereich eine zweite Gruppe von Strahlungsfächern abgeleitet. Eine besonders vorteilhafte Weiterbildung der erfindungsgemäßen Lehre sieht jedoch vor, daß die Sensormittel eine nicht gefüllte Apertur aufweisen, insbesondere durch wenigstens zwei Sensorzeilen, die jeweils zeilenförmig angeordnete Sensoren aufweisen, gebildet sind. Da Sensoranordnungen mit nicht gefüllter Apertur kostengünstiger herstellbar sind als Sensoranordnungen mit gefüllter Apertur, ist auf diese Weise der apparative Aufwand zur Durchführung des erfindungsgemäßen Verfahrens herabgesetzt.

Grundsätzlich sind hierfür zwei Sensorzeilen ausreichend. Es können jedoch auch mehr als zwei Sensorzeilen vorhanden sein, beispielsweise um in der oben angegebenen Weise ein räumlich abgegrenztes Beobachtungsgebiet durch wenigstens drei räumlich zueinander orientierte Strahlungsfächer zu bilden. Die Anordnung der Sensorzeilen relativ zueinander ist hierbei räumlich und/oder flächig in beliebiger Weise entsprechend den jeweiligen Anforderungen wählbar.

Zweckmäßigerweise wird ein Schnittgebiet jeweils durch wenigstens einen Strahlungsfächer, der der ersten Sensorzeile zugeordnet ist, und wenigstens einen Strahlungsfächer, der der zweiten Sensorzeile zugeordnet ist, gebildet. In entsprechender Weise kann dann, wenn mehr als zwei Sensorzeilen verwendet werden, ein Schnittgebiet durch mehrere Strahlungsfächer gebildet werden, wobei von jeder Sensorzeile jeweils wenigstens einer der Strahlungsfächer herrührt.

Eine andere außerordentlich zweckmäßige Weiterbildung der erfindungsgemäßen Lehre sieht vor, daß das Signal, dessen einfallende Empfangsleistung oder -energie bestimmt wird, durch an einer Meteoritenspur wenigstens eines sich in der Erdatmosphäre bewegenden Meteoriten reflektierte und/oder gebeugte Radiowellen gebildet ist. Die meteorische Ausbreitung von Radiowellen ist dem Fachmann allgemein bekannt. Sie beruht darauf, daß Radiowellen an Meteoritenspuren (meteor trails) reflektiert und/oder gebeugt werden, die von sich in der Erdatmosphäre bewegenden Meteoriten erzeugt werden. Ein von einem Sender gesendetes Signal kann aufgrund der Reflexion oder Beugung an der Meteoritenspur von einem Empfänger empfangen werden. Da die Meteoritenspur ein flüchtiges Gebilde ist, beträgt die nutzbare Übertragungsdauer über eine Meteoritenspur in Abhängigkeit von der Art des Meteoriten, seiner Eintrittsgeschwindigkeit und der Frequenz zwischen einigen Millisekunden und Sekunden bis hin zu Minuten.

Ein Beispiel für ein System, das auf einer meteorischer Ausbreitung beruht, ist das C3 meteor burst network für Verbindungen zwischen dem Kontinentalgebiet der USA, Alaska und Kanada. Eine wichtige Eigenschaft von Übertragungssystemen, die auf meteorischer Ausbreitung, ist deren schwere Stör- und Aufklärbarkeit.

Aus geometrischen Gründen ist in erster Näherung die Verbindung über eine Meteoritenspur nur zwischen solchen Stationen möglich, die sich in den Brennpunkten eines Ellipsoids befinden, der tangential an der Meteoritenspur anliegt. Das Gebiet, in dem das Signal empfangen werden kann, wird als "footprint" bezeichnet. Bei einer Übertragungsstrecke von 500 km beträgt der Durchmesser des Bereichs mit 90% Empfangswahrscheinlichkeit ca. 20 km. Für Empfänger außerhalb des footprint nimmt die Empfangswahrscheinlichkeit schnell ab. Derartige Übertragungssysteme arbeiten mit sogenannten "bursts". Eine solche Übertragung basiert auf dem Prinzip, daß eine Station im Netz, beispielsweise die Basisstation ein "idle"-Signal sendet. Kann eine betreffende andere Station das "idle"-Signal über eine Meteoritenspur empfangen, so öffnet sie ihren Datenpuffer und sendet. Gleichzeitig und in Rückmeldung öffnet die Basisstation ihren Datenpuffer und überträgt diesen im Duplexverfahren. Reicht die Meteoritenspur für eine Verbindung nicht mehr aus, so schalten die Datensender ab, und die Basisstation sendet nur das "idle"-Signal.

In diesem Zusammenhang besteht der Vorteil des erfindungsgemäßen Verfahrens einerseits darin, daß erfindungsgemäß gleichzeitig mit hohem Antennengewinn in einer Vielzahl von Beobachtungsrichtungen gemessen werden kann, um alle in Frage kommenden Meteoritenspuren zur Auswertung gebracht und für eine Datenübertragung genutzt werden können. Demgegenüber ist bei bekannten Verfahren, bei denen mit hohem Antennengewinn und einer daraus resultierenden hohen Richtwirkung gearbeitet wird, aufgrund der hohen Richtwirkung das Beobachtungsgebiet und damit die Anzahl der für eine Übertragung in Frage kommenden Meteoritenspuren stark eingeschränkt. Auf diese Weise ist es möglich, die Kanalkapazitäten von Übertragungssystemen, die auf meteorischert Ausbreitung erheblich zu steigern.

Andererseits besteht der Vorteil des erfindungsgemäßen Verfahrens darin, daß über eine Vermessung einer Meteroritenspur, über die zu einem bestimmten Zeitpunkt gerade übertragen wird, der zugehörige Ellipsoid, der tangential an der Meteoritenspur anliegt, bestimmbar ist. Nach Bestimmung des Ellipsoides ist mit der Kenntnis, daß sich die an der Übertragung beteiligten Stationen in den Brennpunkten des Ellipsoides befinden, eine räumliche Ortung der an der Übertragung beteiligten Stationen möglich.

Eine Weiterbildung der vorgenannten Ausführungsform sieht vor, daß durch gleichzeitige Wahl von wenigstens zwei Beobachtungsrichtungen oder Beobachtungsgebieten gleichzeitig wenigstens zwei von den Meteoritenspuren unterschiedlicher Meteoriten reflektierte oder gebeugte Signale empfangen werden. Dadurch ist es möglich, im Gleichkanalbetrieb gleichzeitig mehrere footprints empfangstechnisch zu bedienen.

Weitere vorteilhafte und zweckmäßige Ausführungsformen sind in den weiteren Unteransprüchen angegeben.

Die Erfindung wird nachfolgend anhand der beigefügten Zeichnungen, in denen Ausführungsbeispiele dargestellt sind, näher erläutert.

Es zeigen
- Fig.1: ein Beispiel für die Bildung eines nicht redundanten Hauptsignalraumes durch Wiederzusammenführung und Summenbildung der Ausgänge einer Strahlungsfächer formenden Vorrichtung,
- Fig. 2: ein Beispiel für die Bildung eines redundanten Hauptsignalraumes durch Wiederzusammenführung und Summenbildung der Ausgänge von zwei Strahlungsfächer formenden Vorrichtungen,
- Fig. 3: ein Beispiel zur Bildung von komplementären, nicht redundanten Hauptsignalräumen,
- Fig. 4: ein Beispiel eines Extremfalles von zwei nicht vollständig komplementären, nicht redundanten Hauptsignalräumen, die sich nur in einem Schnittgebiet aus zwei Fächern der jeweiligen Hauptsignalräume schneiden,
- Fig.5: ein Beispiel für die Bildung eines Schnittgebiets-Signalraumes durch Korrelation aus zwei sich durchdringenden Strahlungsfächern,
- Fig. 6: ein Beispiel für die Bildung eines Fächer-Signalraumes durch Korrelation eines nicht redundanten Hauptsignalraumes mit einem Strahlungsfächer,
- Fig. 7: die Bildung von Signalräumen,
- Fig. 8a: eine schematische Veranschaulichung eines Ausführungsbeispiels des erfindungsgemäßen Verfahrens mit komplementären, nicht redundanten Hauptsignalräumen und orthogonaler Anordnung der Strahlungsfächer,
- Fig. 8b: eine schematische Veranschaulichung eines weiteren Ausführungsbeispiels des erfindungsgemäßen Verfahrens entsprechend Fig. 8a, jedoch mit einer anderen Verknüpfung (Multiplikation und Summation umgekehrt gegenüber Fig. 8a),
- Fig. 9a: eine schematische Anordnung zur Verknüpfung von Strahlungsfächern bei dem Verfahren gemäß Fig. 8a,
- Fig. 9b: ein Fließbild des Ablaufes des Verfahrens gemäß Fig. 8a,
- Fig. 10: eine schematische Veranschaulichung eines weiteren Ausführungsbeispiels des erfindungsgemäßen Verfahrens mit nur einem Hauptsignalraum, welcher redundant oder auch nicht redundant sein kann,
- Fig.11a: eine schematische Anordnung zur Verknüpfung von Strahlungsfächern bei dem Verfahren gemäß Fig. 10,
- Fig.11b: ein Fließbild des Ablaufs des Verfahrens gemäß Fig. 10,
- Fig. 12: eine schematische Anordnung zur Verknüpfung von Strahlungsfächern bei einem Verfahren mit der Option zur Verarbeitung nicht idealer Komplementät beider Hauptsignalräume,
- Fig. 13: eine Darstellung, die die Verknüpfung verschiedener Signalräume und Zwischenergebnisse zeigt,
- Fig. 14: ein Blockdiagramm eines Ausführungsbeispieles einer erfindungsgemäßen Vorrichtung zur Durchführung des erfindungsgemäßen Verfahrens.

Die Abbildungen in der Zeichnung sind schematisch und beinhalten, daß in einer realen Apparatur aus einer Anzahl betriebsnotwendiger Funktionsgruppen, die Schnittstellen zu einzelnen Verfahrensabläufen an konstruktiv sinnvollen Stellen der realen Aufnahme- oder Auswerteinheit vorgenommen oder lokalisiert werden können.

Die in den Abbildungen gezeigten Diagrammpiktogramme treten in dem Verfahren realerweise als zeitliche Signalfolgen auf und dienen hier der Veranschaulichung, um unterschiedliche Signalfolgen und Signalräume kenntlich zu machen.

Erfindungsgemäß wird aus einer vorgebbaren oder wählbaren Anzahl von Strahlungsfächern, nachfolgend auch kurz als Fächer bezeichnet, ein sogenannter Hauptsignalraum gebildet und hieraus ein Maß dafür bestimmt, inwieweit jeder einzelne Fächer zur Gesamtheit der aufgenommenen Empfangsleistung- oder Energie beiträgt. Ist dies für jeden betrachteten Fächer bekannt, dann wird beispielsweise durch Korrelation von einzelnen Fächern ein Schnittgebiet gebildet, welches wiederum ein Maß dafür angibt, welchen Teil das Schnittgebiet zur aufgenommenen Empfangsleistung- oder Energie der am Schnittgebiet beteiligten Fächer beiträgt. Durch technische Maßnahmen zur kombinatorischen Verknüpfung wird dann bestimmt, welchen Teil das Schnittgebiet zur dem Hauptsignalraum zugeordneten Gesamtempfangsleistung oder - energie beiträgt. Die Bestimmung der Empfangsleistung- oder Energie zu jeder Beobachtungsrichtung erfolgt damit konfusionsfrei, d. h. frei von Mehrdeutigkeiten, die durch aus anderen Richtungen einfallende Leistung oder Energie verursacht werden, und eindeutig in Bezug auf jede andere Signalquelle aus anderen Schnittgebietsrichtungen.

Die Korrelation wird als technischer Prozeß definiert, in welchem zwei Signalfolgen in einer entsprechenden analogen oder digitalen Apparatur miteinander multipliziert werden. Eine darauf ggf. folgende Mittelung kann bei entsprechendem Bedarf als infinitesimal klein angenommen werden, womit sich die Korrelation in einer realen technischen Apparatur auf eine Multiplikation reduzieren kann und die Mittelung gegebenenfalls nur noch durch eine endliche frequenzmäßige Bandbegrenzung bestimmt ist. Die Korrelationsmittel werden in den Abbildungen mithin durch das Multiplikationszeichen dargestellt werden. Längere Integrationszeiten sind bei Bedarf entsprechend apparativ zu bilden.

Mit dem Begriff Schnittgebiet wird das diagrammäßige Kollektiv derjenigen Strahlungsfächer oder -konusse bezeichnet, deren gegenseitige Durchdringung vornehmlich, aber nicht notwendigerweise ausschließlich, in einer bestimmten Hauptstrahlrichtung festgelegt ist.

Als Richtungen oder als räumlich, richtungsbestimmt gelten hier auch diejenigen Richtungswerte, welche die Schnittgebiete und Strahlungsfächer in affiner Abbildung, zweidimensional auf Flächen abbilden.

Als Signal werden im technischen Sinn alle in der Zeit physikalisch darstellbaren Funktionen verstanden, welche von einer Sensoranordnung aufgenommen werden können. Beispielsweise können die Signale durch elektromagnetische Strahlung, insbesondere HF-Signale, akustische Signale, Wärmestrahlung oder radioaktive Strahlung, gebildet sein. Die von dem Verfahren ausgeführte Funktion umfaßt somit nicht nur die Verarbeitung spektral diskreter Signale, sondern unter anderem auch die Verarbeitung rauschverteilter Signale oder Kombinationen daraus.

Das Verfahren basiert vorzugsweise auf einer Antennen- oder Sensoranordnung mit nicht gefüllter Apertur mit einer gegebenen Menge von Strahlungsfächern in frei vorgebbarer räumlicher Verteilung. Zumindest über einen Meßgang gilt dieses System aus Strahlungsfächern und Strahlrichtungen ad hoc als fest vorgegeben und eindeutig bestimmt. Hiermit grenzt sich das Verfahren im Wesen seiner Funktion gegen sogenannte Schätzverfahren ab, welche in der Regel eine Verbesserung der Diagrammeigenschaften anstreben. Weiterhin grenzt sich das Verfahren gegen Schätzverfahren, adaptive Verfahren oder ähnliche Verfahren dadurch ab, daß der Funktionsablauf völlig deterministisch ohne Iterationen oder Rückkopplungen erfolgt.

Die Einführung dieser technischen Vorgaben ermöglicht es, die bei bekannten Verfahren vorhandenen Mehrdeutigkeiten mittels eines nach Signalräumen strukturierten Verfahrens mit sehr hoher Verarbeitungsgeschwindigkeit aufzulösen.

Der Begriff Signalraum ersetzt hier den Begriff Diagramm, da das Verfahren nicht im klassischen Sinn das Diagramm, sondern die darüber aufgenommenen und in Signalräumen zusammengefaßten zeitlichen Signalfolgen verarbeitet. Im Verarbeitungsprozeß sind die Begriffe in der Regel identisch, jedoch nicht im Ergebnis der eigentlichen Funktion des Verfahrens.

Jeder einzelne vorgegebene Strahlungsfächer sowie jedes einzelne durch Korrelation gebildete Schnittgebietsdiagramm entsprechen mithin einem Signalraum, der nach dem Diagrammtyp klassifizierbar ist und wiederum aus anderen Signalräumen gebildet werden kann. Das Verfahren bildet zusätzliche Signalräume und führt darin weitere Korrelationen aus.

Wesentlicher Bestandteil des erfindungsgemäßen Verfahrens ist die Bildung bzw. Schaffung mindestens eines Hauptsignalraums, welcher von besonderer Beschaffenheit zu sein hat und Nebenbedingung zu der oben erwähnten Antennenanordnung einführt. Ein Hauptsignalraum umfaßt die Summe aller hierzu vorgegebenen Fächerdiagramme in der Form, daß jeder Fächer Element des Hauptsignalraums ist und sich selber darin abbildet. Ein Haupsignalraum hat die Aufgabe zu erfüllen, die gesamte einfallende Signalleistung- oder Energie aus dem gesamten, von allen ausgewählten Fächern abgedeckten Gebiet zu repräsentieren.

Zur Bildung des Hauptsignalraumes können die Strahlungsfächer herangezogen werden. Beispielsweise kann der Hauptsignalraum durch vektorielle Summation sämtlicher oder einiger der Strahlungsfächer gebildet werden. Der Hauptsignalraum kann jedoch auch durch ein von einer Zusatzsensoranordnung erzeugtes Diagramm gebildet werden, das nach Form und Wichtung der diagrammäßigen Berandungskurve über alle Strahlungsfächer entspricht. Ein solcher Zusatzsensor, beispielsweise bei HF-Signalen eine zusätzliche Antenne, kann vom Verfahren optional verwendet werden.

Da jeder Fächer sich idealerweise identisch im Hauptsignalraum abbilden soll, ist bei der Anordnung der Fächer zu beachten, daß insbesondere eine vektorielle Summation über alle sich schneidenden Fächer, eine Wichtung in den Schnittgebieten ergibt.

Beispielsweise ergeben zwei sich schneidende Fächer gemäß der durch die Zusammenschaltung erhöhten Richtwirkung im Schnittgebiet eine diagrammäßige Wichtung von 3dB. Diese Wichtung kann im Verfahren von Vorteil sein oder aber optional nach Erfordernis im Endergebnis über die gewählte Fächergeometrie wieder rückgängig gemacht werden.

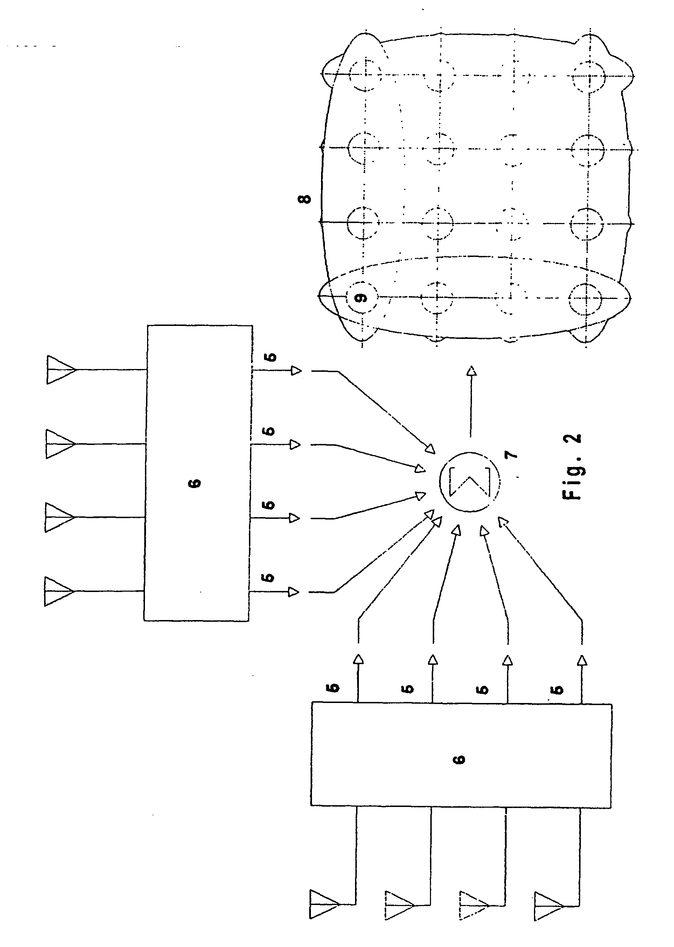

Ein Hauptsignalraum, der aus sich schneidenden Fächern gebildet wird, soll als redundant bezeichnet werden. Fig. 2 zeigt ein Beispiel für die Erzeugung eines solchen redundanten Hauptsignalraums 8 durch Wiederzusammenführung und Summenbildung 7 der Ausgänge 5 von zwei Strahlungsfächer formenden Vorrichtungen 6, deren Strahlungsfächer 5 sich in Schnittgebieten 9 durchdringen. Durch die Summenbildung 7 erfolgt eine Wichtung der Schnittgebiete 9. Eine Anzahl von mehr als zwei Strahlungsfächer formenden Vorrichtungen 6 ist möglich. Die den Hauptsignalraum 8 bildenden Strahlungsfächer 5 brauchen nicht notwendigerweise identische Form oder Wichtung zu haben.

Eine vereinfachende Möglichkeit zur Bildung eines redundanten Hauptsignalraums besteht darin, zu jedem einzelnen Schnittgebiet eine gleiche Anzahl formmäßig identischer Fächer vorzugeben. Hieraus ergeben sich im wesentlichen identische Schnittgebiete mit gleicher Wichtung.

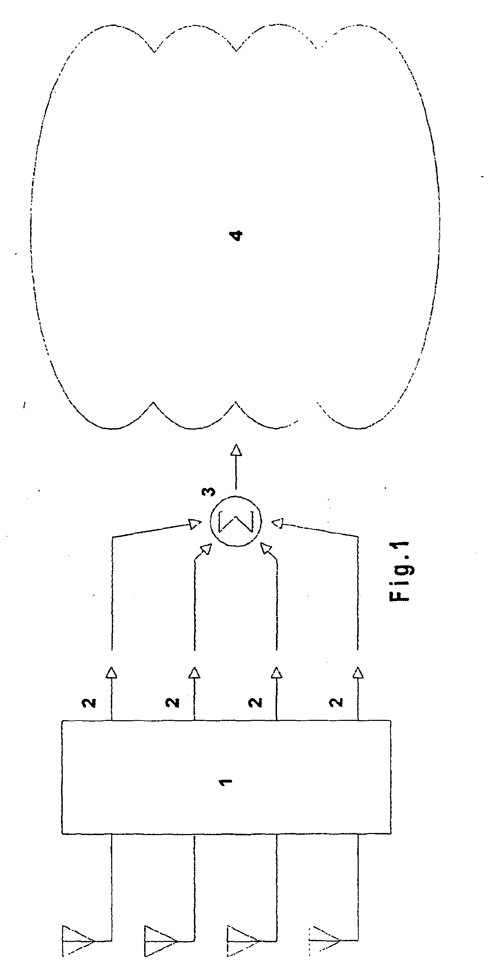

Ein nicht redundanter Hauptsignalraum vermeidet zusätzliche Wichtungen über das Gesamtgebiet dadurch, daß keine sich gegenseitig durchdringenden Fächer (Es gilt hierzu sinngemäß die Definition zu sich durchdringenden Strahlungsfächern in Bezug auf die Diagrammeigenschaften von realen Antennen- bzw. Sensoranordnungen mit endlicher Nebenkeulenunterdrückung.) zur Bildung des Hauptsignalraums zulässig sind. Fig. 1 zeigt ein Beispiel für die Erzeugung eines nicht redundanten Hauptsignalraums 4 durch Wiederzusammenführung und Summenbildung 3 der Ausgänge 2 einer Strahlungsfächer formenden Vorrichtung 1. Die den Hauptsignalraum 4 bildenden Strahlungsfächer 2 brauchen nicht notwendigerweise identische Form oder Wichtung zu haben.

Ein nicht redundanter Hauptsignalraum wird deshalb durch die Summe derjenigen Anzahl sich nicht schneidender Fächer gebildet, welche als Teilmenge der aus dem Gesamtsystem gewählten Fächeranzahl, der vorbestimmbaren räumlichen Gesamtverteilung oder Überdeckung entsprechen.

Vorteil eines nicht redundanten Signalraums ist, daß die Fächerdiagramme sich darin relativ genau abbilden und keine Wichtungen eingeführt werden. Zum Begriff der Wichtung gilt analog die Definition zu sich durchdringenden Strahlungsfächern in realen Antennen- bzw. Sensoranordnungen.

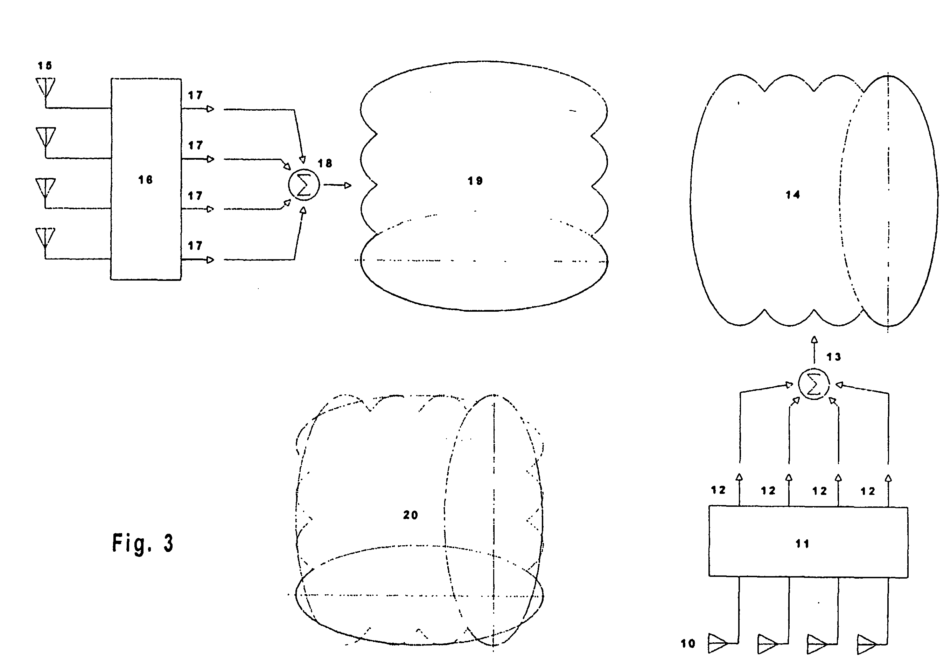

Das Komplement zu einem nicht redundanten Hauptsignalraum ist der Teil von Fächern aus einem Gesamtsystem, welche diesen in Schnittgebieten durchdringen und darüberhinaus zusammengefaßt, selber einen nicht redundanten Hauptsignalraum bilden. Fig. 3 zeigt ein Beispiel zur Bildung von komplementären, nicht redundanten Hauptsignalräumen 14,19. Zwei beispielsweise orthogonal zueinander stehende Antennen- bzw. Sensorzeilen 10,15 bilden jeweils in einer strahlformenden Vorrichtung 16,11 eine Anzahl von Fächern in x-Koordinatenrichtung 17 und eine entsprechende Anzahl von Fächern in y-Koordinatenrichtung 12, welche durch Summation in 13,18 entsprechende nicht redundante Hauptsignalräume 14,19 bilden. Hauptsignalraum 14 und Hauptsignalraum 19 sind komplementär. Physikalisch unvermeidliche Unzulänglichkeiten in der Formung von Diagrammen, wie z.B. endliche Nebenkeulenunterdrückung in den Strahlungsfächern sind im realen Anwendungsfall zu berücksichtigen, z.B. Überdeckung in den Randlagen, wenn beispielsweise der Hauptsignalraum 14 und Hauptsignalraum 19 gemäß Abbildung zu Bezugszeichen 20 ineinander abgebildet werden.

Ist eine vollständige Abdeckung durch alle möglichen Schnittgebiete oder Strahlungsfächer 12,17 nicht notwendig, brauchen sich die komplementären, nicht redundanten Hauptsignalräume 14,19 auch nicht notwendigerweise vollständig identisch ineinander abbilden. Der Begriff komplementär ist entsprechend einer Skala zum Grad des Komplements relativ.

Das erfindungsgemäße Verfahren kann ferner vorsehen, daß nur ein nicht redundanter Hauptsignalraum, beispielsweise entweder der Hauptsignalraum 14 oder aber der Hauptsignalraum 19, zur Auswertung herangezogen wird. Das Komplement zu einem nicht redundanten Hauptsignalraum ist unter Berücksichtigung des Grads des Komplements nicht notwendigerweise erforderlich. Redundanten Hauptsignalräumen ist der Überdeckungsbereich ad hoc vorgebbar.

Es können weiterhin auch andere komplementäre, nicht redundante Hauptsignalräume aus anderen als sich orthogonal durchdringenden Fächeranordnungen wie auch mit mehr als zwei Antennen- bzw. Sensorzeilen konstruiert werden. Die Abbildung zu Bezugszeichen 20 in Fig. 3 zeigt ein Beispiel der voneinander unabhängigen, aber dennoch im wesentlichen gleichen räumlichen Überdeckung einmal durch den Hauptsignalraum 14 und zum anderen durch den Hauptsignalraum 19, entsprechend dem hohem Grad des Komplements.

Es sei angemerkt, daß eine Summation der Hauptsignalräume 14 und 19 hingegen einen eigenständigen, nunmehr redundanten Hauptsignalraum in der Berandung von 20 bilden würde. Mit anderen Worten gilt: Ein zu einem anderen, nicht redundanten Hauptsignalraum ideal komplementärer, nicht redundanter Hauptsignalraum besteht aus einer anderen Teilmenge der Fächer, welche sich selber ebenfalls nicht schneiden, im Idealfall ebenfalls die vorgegebene räumliche Verteilung überdecken, aber andererseits die komplementären Schnittgebietsfächer zum anderen Teil des Hauptsignalraums sind. Vollständig bzw. ideal komplementäre, nicht redundante Signalräume können aufgrund ihrer Identität unabhängig voneinander als Hauptsignalraum deklariert werden. Es ist möglich, daß mehr als zwei Signalräume komplementäre Hauptsignalräume bilden. Ideal komplementäre, nicht redundante Hauptsignalräume bilden sich in ihrer Gesamtverteilung genau ineinander ab.

Es ist erfindungsgemäß insbesondere auch möglich, daß zwei oder mehr an einem System beteiligte, nicht redundante Hauptsignalräume nicht notwendigerweise vollständig komplementär zu sein brauchen und mithin auch nicht das genaue Komplement zueinander bilden müssen. Das heißt, als komplementär sollen auch diejenigen nicht redundanten Hauptsignalräume bezeichnet werden, welche über Teilmengen, verfügen die kein Element eines anderen am System beteiligten nicht redundanten Hauptsignalraums sind.

Erfindungsgemäß ist lediglich mindestens ein Schnittgebiet notwendig, welches aus je einem Strahlungsfächer des einen nicht redundanten Hauptsignalraums und einem Strahlungsfächer eines anderen Hauptsignalraums gebildet wird. Ein Beispiel hierfür ist, daß beispielsweise zwei nicht redundante Hauptsignalräume, zudem möglicherweise in unterschiedlicher Größe, angenommen werden, die als einziges gemeinsames Element ein einziges Schnittgebiet haben, das durch zwei Strahlungsfächer gebildet wird, die aus je einem dieser Hauptsignalräume herausragen.

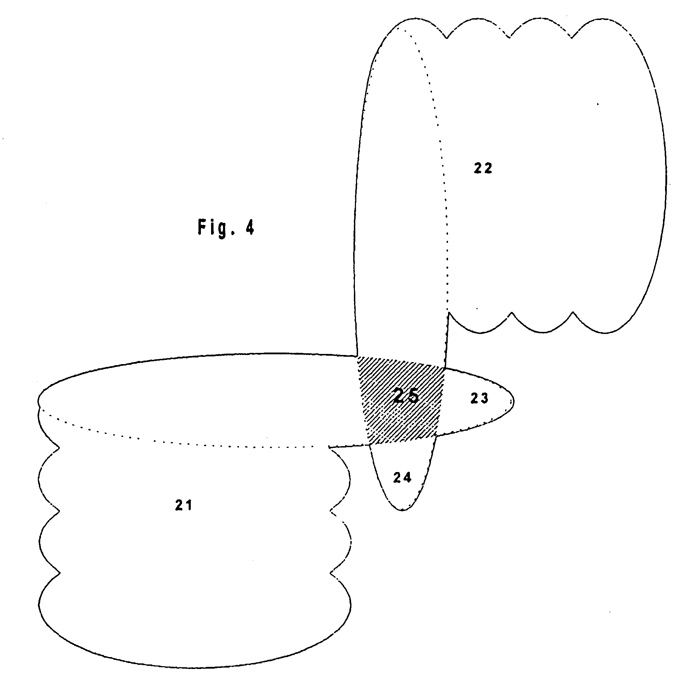

Fig. 4 zeigt ein Beispiel eines solchen Falls von zwei nicht vollständig komplementären, nicht redundanten Hauptsignalräumen 21 und 22, die sich nur in einem Schnittgebiet 25 aus zwei Fächern 23,24 der jeweiligen Hauptsignalräume 21,22 schneiden. Bei nicht vollständig komplementären, nicht redundanten Hauptsignalräumen kann eine Vergleichbarkeit der Fächer 23, 24 mit dem Schnittgebiet 25 dadurch erreicht werden, daß das Verhältnis der in 21 und 22 enthaltenen Leistungs- bzw. Energiepegel bestimmt wird. Da das Verfahren erfindungsgemäß weiterhin bestimmen kann, welchen Beitrag jeder Fächer 23,24 zur Gesamtleistung- bzw. Energie des zugehörigen Hauptsignalraums 21 oder 22 beiträgt, können die mit dem Verhältnis gewichteten Fächer 23,24 ein eindeutiges Ergebnis zum Schnittgebiet 25 liefern. Da das erfindungsgemäße Verfahren es ermöglicht, zunächst zu jedem dieser Strahlungsfächer den Leistungs- bzw. Energiebeitrag zu bestimmen, den der jeweilige Fächer zu seinem Hauptsignalraum beiträgt, ist auch der Beitrag des Schnittgebiets zur aufgenommenen Gesamtleistung- bzw. Energie bestimmbar, wenn das Verhältnis der von diesen Hauptsignalräumen aufgenommenen Gesamtleistung- bzw. Energie untereinander bekannt ist. Die in einem jeweiligen nicht redundanten Hauptsignalraum zusammengefaßte Gesamtleistung - bzw. Energie aus der zugehörigen Anzahl von Fächern ist deshalb in das Verhältnis zur Gesamtleistung- bzw. Energie zu setzen, welche in den anderen am System beteiligten Hauptsignalräume zusammengefaßt ist. Es ist hier nicht zu ermitteln, welchen Beitrag ein Hauptsignalraum zu einer möglichen zusammengefaßten Leistung- bzw. Energie aus allen Hauptsignalräumen beiträgt, sondern in welchem Verhältnis die Gesamtleistung- bzw. Energie eines einzelnen nicht redundanten Hauptsignalraum zum Ganzen der Gesamtleistung- bzw. Energie eines anderen am System beteiligten nicht redundanten Hauptsignalraums steht.

Es können prinzipiell alle bekannten analogen oder digitalen Verfahren zur Verhältnisbildung von Leistungs- bzw. Energiepegeln zur Anwendung kommen, weshalb das Verfahren im Fall der Verhältnisbildung von nicht redundanten Hauptsignalräumen hier auch Divisionsoperationen zuläßt. Ansonsten benötigt das Verfahren keine Divisionsoperationen. Das Ergebnis der Verhältnisbildung kann beispiels weise die Aussage haben, die Gesamtleistung- bzw. Energie in einem nicht redundanten Hauptsignalraum ist um einen Faktor 'x' größer als die Gesamtleistung- bzw. Energie eines anderen nicht redundanten Hauptsignalraums. Die Vergleichbarkeit nicht ideal komplementärer, nicht redundanter Hauptsignalräume ist für reale Antennen- bzw. Sensoranordnungen von besonderem Vorteil, da diese aufgrund von realen Diagrammgegebenheiten kein ideales Komplement von einzelnen nicht redundanten Hauptsignalräumen liefern.

Es ist zu beachten, daß prinzipiell eine Zusammenfassung auch der komplementären, nicht redundanten Hauptsignalräume möglich wäre, man sich aber dann zu vergegenwärtigen hat, das nicht redundante Hauptsignalraum-Prinzip zu verlassen, da die dann zusammengefaßten Hauptsignalräume sich schneidende Strahlungsfächer im Sinn von redundanten Hauptsignalräumen einführen würden.

Als Hauptsignalraum sollen auch diejenigen Formen gelten, bei denen Hauptsignalräume auf Strahlungsfächerform degenerieren oder degeneriert sind. Das heißt, besteht das gesamte System als Minimalkonfiguration aus nur zwei sich schneidenden Fächern, dann bildet jeder Fächer für sich einen nicht redundanten Hauptsignalraum und für den Fall der Zusammenfassung beider Fächer dementsprechend einen redundanten Hauptsignalraum. Da zwei einzelne sich durchdringende Strahlungsfächer definitionsgemäß ein Schnittgebiet bilden und sich in der Regel dabei nicht identisch ineinander abbilden, sind zwei als nicht redundante Hauptsignalräume betrachtete einzelne Strahlungsfächer deshalb auch nicht vollständig zueinander komplementär. Um das vom Verfahren angestrebte Ergebnis für das Schnittgebiet zu finden, müssen auch in dem Fall, in welchem zwei einzelne Strahlungsfächer Hauptsignalräume darstellen, Verknüpfungen zwischen dem korrelierten Schnittgebiet, den Fächern bzw. den entsprechenden Hauptsignalräumen vorgenommen werden. Es kann somit gezeigt werden, daß die Systematik des Verfahrens sich auch folgerichtig auf den Fall anwenden läßt, in welchem Hauptsignalräume zu Strahlungsfächern degenerieren bzw. von diesen direkt repräsentiert werden. Neben der nach wie vor notwendigen Verknüpfung mit Verfahren oder Apparaturen entsprechend der Funktion kombinatorischer Wahrscheinlichkeitsrechnung ist insbesondere für den Fall der Bildung eines redundanten Hauptsignalraums ersichtlich bzw. von der Systematik des Verfahrens gefordert, daß zwei die Minimalkonfiguration darstellende Strahlungsfächer eben dennoch zusammengefaßt werden müssen. Das erfindungsgemäße Verfahren umfaßt deshalb auch den Fall der Sonderformen von Hauptsignalräumen. Hieraus läßt sich ableiten, daß dies auch für in irgendeiner Form permutativ zusammengesetzte und schrittweise in vergrößernder Weise gebildete Hauptsignalraum-Konfigurationen gilt.

Zur Durchführung des Verfahrens kann ein Hauptsignalraum über eine entsprechende Zusatzantenne oder über die zur Verfügung stehenden Strahlungsfächer gebildet werden. Letzteres kann mit der Bildung eines redundanten oder aber eines nicht redundanten Hauptsignalraums erfolgen.

Eine Beispielsapparatur zur Erzeugung eines Hauptsignalraums ist eine Butler-Matrix, welche an den Ausgängen eine Anzahl richtungsmäßig aufeinanderfolger Strahlungsfächer bereitstellt. Die durch die Butler-Matrix erzeugte Richtungsaufteilung wird durch vektorielle Summation der Ausgangssignale wieder rückgängig gemacht, wodurch sich die Summe der durch die Butler-Matrix geformten fächerförmigen Strahlungsdiagramme (Strahlungsfächer) ergibt. Selbstverständlich kann die Zusammenführung an jeder beliebigen Stelle erfolgen, die im Funktionsablauf einer realen Empfangs- bzw. Auswerteinheit sinnvoll ist. Die Form des Hauptsignalraums kann in diesem Beispiel als Berandungskurve um alle von der Butler-Matrix gebildeten Strahlungsfächer angesehen werden. Der Signalraum wäre hier zudem nicht-redundant, da sich die Fächer der Butler-Matrix nicht schneiden. Es gilt sinngemäß die Definition zu sich durchdringenden Strahlungsfächern in Bezug auf die Diagrammeigenschaften von realen Antennen- bzw. Sensoranordnungen mit endlicher Nebenkeulenunterdrückung.

Der komplementäre Hauptsignalraum würde aus der Summe der Fächer einer identischen, aber orthogonal zu den Fächern der ersten Butler-Matrix stehenden, zweiten Butler-Matrix gebildet. Gleiche Ergebnisse können natürlich auch mit einer entsprechenden anderen analogen oder digitalen strahlformenden Vorrichtung, beispielsweise einem Netzwerk, erzielt werden.

Grundsätzlich können erfindungsgemäß Hauptsignalräume durch alle herkömmlichen und bekannten analogen sowie digitalen Verfahren oder Vorrichtungen zur diagrammäßigen Verarbeitung von Antennen- oder Sensoranordnungen bzw. eben daraus gebildeter Strahlungsfächer, erzeugt werden.

Die Ergebnisbildung des erfindungsgemäßen Verfahrens erfolgt beispielsweise über verschiedene Korrelationsvorgänge innerhalb der Signalräume, um hieraus Werte zu bilden, die in weiteren Verfahrensabläufen in der gewünschten Weise zu Meßergebnissen mit eindeutiger Aussage verknüpft werden.

Das Verfahren macht sich den Gedanken zunutze, daß alle Signalräume aus einer Menge rauschverteilter, zeitlicher Signale bestehen mögen, wobei jeder Signalraum wiederum in multivariate, rauschverteilte Räume aufteilbar ist.

Nimmt man beispielsweise zwei voneinander unabhängige gaußverteilte Rauschsignale an und führt diese zusammen, dann ergibt sich hieraus wiederum ein sogenanntes bivariates, gaußverteiltes Rauschsignal. Unter der Annahme, daß beide Rauschsignale beispielsweise aufgrund der Vorgabe einer Mittenfrequenz, den gleichen Erwartungswert haben, so sind die zeitlichen Signalfolgen zwar weiterhin voneinander unabhängig, die Varianz des neu gebildeten bivariaten gaußverteilten Rauschsignals geht hingegen aber bei Korrelation eindeutig bestimmbar aus der Covarianz der Ausgangssignale hervor. Werden mehrere Rauschsignale zusammengeführt, dann bilden diese in entsprechender Weise einen multivariaten Signalraum.

Da das Verfahren die aufgenommene Empfangsleistung- oder -energie auswertet, ist es zulässig, auch ein auf der Frequenzachse diskretes Signal als Signal mit einer gegen Null strebenden Varianz anzusehen, welches dem Wesen realer, technischer Signale zudem recht nahe kommt. Das Verfahren kann beispielsweise die Bestimmung eines Maßes für die Empfangsleistung oder -energie vorsehen, beispielsweise die Bestimmung der relativen bzw. prozentualen Empfangsleistung- oder -energie in Bezug auf einen übergeordneten Signalraum entsprechend einem Hauptsignalraum.

Eine Bestimmung des absoluten Wertes der Empfangsleistung oder -energie in einer Beobachtungsrichtung kann derart erfolgen, daß in einem Meßgang lediglich einmal die gesamte über den Hauptsignalraum aufgenommene absolute Empfangsleistung oder -energie bestimmt wird und hierüber die relativen Meßergebnisse skaliert werden können.

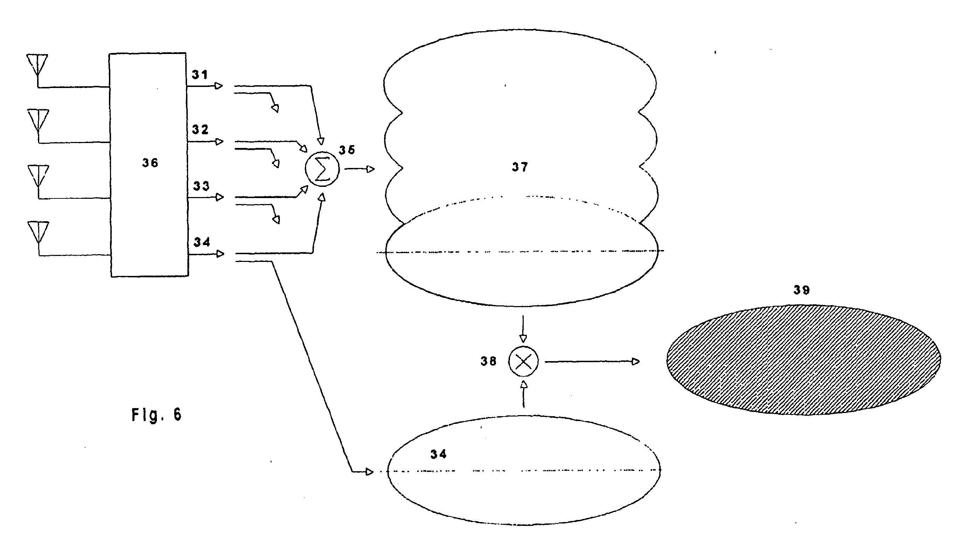

Wesentlicher Bestandteil einer bevorzugten Ausführungsform des erfindungsgemäßen Verfahrens ist, jeden Strahlungsfächer einzeln gegen den Hauptsignalraum zu korrelieren. Fig. 6 zeigt die Bildung eines Fächer-Signalraumes 39 durch Korrelation 38 eines nicht redundanten Hauptsignalraumes 37 mit einem aus Bezugszeichen 31 bis 34 gewählten Strahlungsfächer, beispielsweise hier dem Fächer 34. Zur Bildung eines Fächer-Signalraumes 39 sind redundante Hauptsignalräume gleichermaßen geeignet und zulässig. Das durch den Fächer-Signalraum 39 dargestellte Korrelationsergebnis ist ein Wahrscheinlichkeitsmaß dafür, welchen Beitrag der Strahlungsfächer 34 zur über den Hauptsignalraum 37 aufgenommenen Gesamtleistung- oder Energie beiträgt. Die den Hauptsignalraum 37 bildenden Strahlungsfächer 31 bis 34 brauchen nicht notwendigerweise identische Form oder Wichtung haben. Die Strahlungsfächer 31 bis 34 werden in der Strahlungsfächer formenden Vorrichtung 36 gebildet. Der Hauptsignalraum wird durch vektorielle Summation 35 der Strahlungsfächer 31 bis 34 gebildet. Da das Wesen des Korrelationsergebnis ein statistisches Maß, übertragbar in die Form einer Wahrscheinlichkeit, eines Prozentsatz oder einer Varianz ist, liefert die Korrelation eines Fächers 34 gegen den Hauptsignalraum 37 eine Aussage über die vom Fächer aufgenommene Empfangsleistung- oder Energie in Bezug auf die vom Hauptsignalraum aufgenommene Gesamtleistung oder -energie.

Das Ergebnis ist ein neu gebildeter Fächer-Signalraum 39, welcher angibt, in welchem Maß dieser zu der vom Hauptsignalraum aufgenommenen Gesamt-Empfangsleistung oder -energie beiträgt.

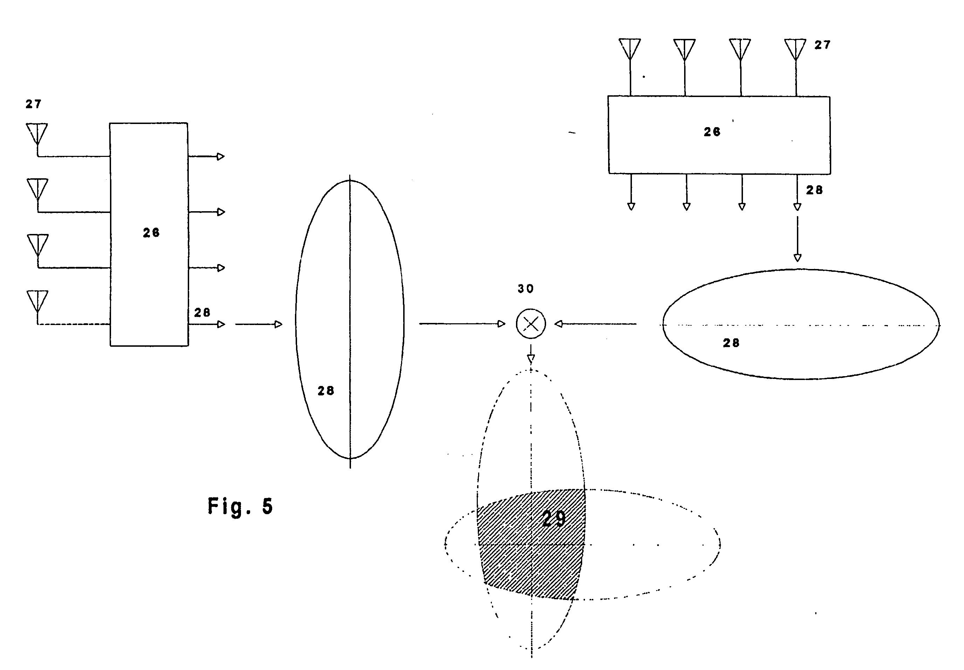

Während der Hauptsignalraum die oberste Signalraumstufe im System darstellt, befinden sich die Schnittgebiete auf der untersten Signalraumstufe. Erzeugt wird ein jeweiliger Schnittgebiets-Signalraum durch Korrelation der an der Bildung des Schnittgebiets beteiligten und von der Apparatur bereitgestellten fächerförmigen Strahlungsdiagramme (Strahlungsfächer). Fig. 5 zeigt die Bildung eines Schnittgebiets-Signalraumes 29 durch Korrelation 30 aus zwei sich durchdringenden Strahlungsfächern 28. Das durch den Schnittgebiets-Signalraum 29 dargestellte Korrelationsergebnis ist ein Wahrscheinlichkeitsmaß darüber, welchen Beitrag das Schnittgebiet 29 zur über die von beiden Strahlungsfächern 28 aufgenommenen Leistung- oder Energie beiträgt. Die Strahlungsfächer 28 werden über die Strahlungsfächer formenden Vorrichtungen 26 aus den von den Antennen- bzw. Sensorzeilen 27 erfaßten Signalen gebildet. Dies ist eine Teilfunktion des neuen Verfahrens, welche in der Ausführung zwar identisch mit dem bekannten synthetischen Strahlbündelungs-Vorgang ist, hier aber nicht in erster Linie zu einer höher bündelnden Diagrammform führen soll, sondern für den weiteren Verfahrensablauf zunächst lediglich einen Zwischenwert liefert.

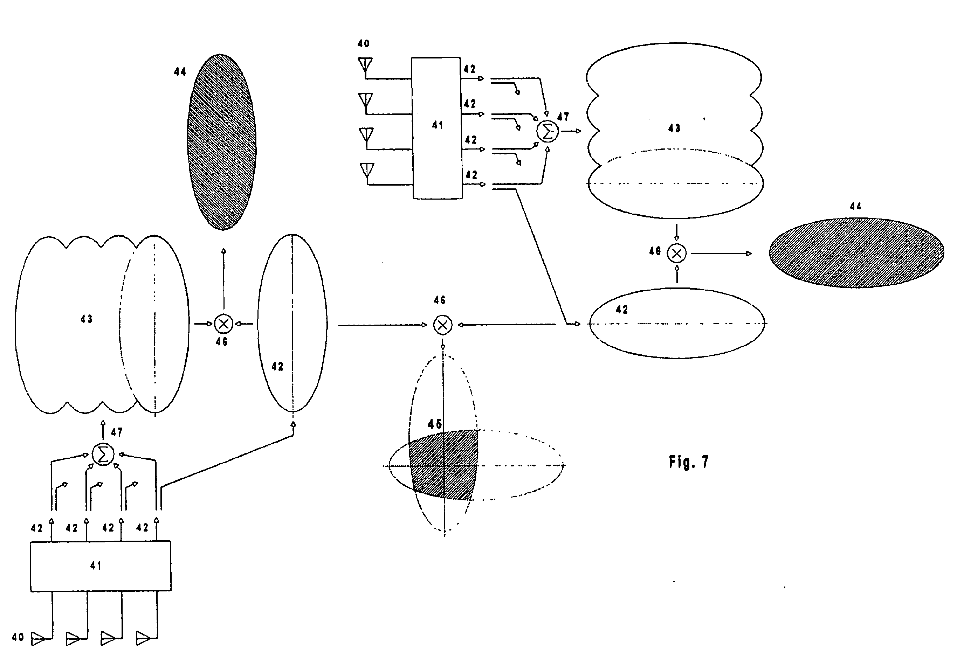

Entsprechend zur Korrelation der Strahlungsfächer gegen den Hauptsignalraum, liefert auch die gegenseitige Korrelation der an der Bildung eines Schnittgebiets beteiligten Strahlungsfächer ein statistisches Maß darüber, welcher Anteil der über die beteiligten Strahlungsfächer aufgenommenen Empfangsleistung- oder Energie eben auf das durch Korrelation gebildete Schnittgebiet entfällt, vgl. Fig. 5, 6 und 7. In Fig. 7 sind zwei Systeme mit sich gegenseitig durchdringenden Strahlungsfächern 42 dargestellt. Beide Hauptsignalräume 43 sind hier beispielsweise komplementär. Fig.7 zeigt die Bildung von Fächer-Signalräumen 44, die Bildung eines Schnittgebiets-Signalraums 45 und die Bildung von Hauptsignalräumen 43 aus einem System von Strahlungsfächern 42, welche durch die Strahlungsfächer formenden Vorrichtungen 41 aus den von den Antennen- bzw. Sensorzeilen 40 empfangenen Signalen gebildet werden. Die Fächer-Signalräume 44 bzw. Schnittgebiets-Signalräume 45 gehen jeweils aus entsprechender Korrelation 46 hervor. Die Hauptsignalräume werden durch Zusammenführung und Summation 47 der Strahlungsfächer 42 gebildet.

Das Ergebnis ist ein neu gebildeter Schnittgebiets-Signalraum, wobei das Ergebnis der Korrelation der beiden in Fig. 7 mit dem Bezugszeichen 42 bezeichneten Fächer, die das Schnittgebiet bzw. den Schnittgebiets-signalraum bilden, angibt, in welchem Maß dieses bzw. dieser zur von den beteiligten Fächern 42 aufgenommenen Empfangsleistung- oder -energie beiträgt.

Die Korrelation kann sowohl in redundanten als auch in nicht redundanten Hauptsignalräumen oder auch in zwischengeschalteten Signalunterräumen erfolgen. Die gebildeten Fächer-Signalräume werden im weiteren Verfahrensablauf mit den gebildeten Schnittgebiets-Signalräumen verknüpft. Es wird allerdings hiermit keine Verhältnisbildung von Signalwerten im Sinne einer Division vorgenommen. Erfindungsgemäß sind Divisionen nicht erforderlich.

Das Verfahren verknüpft die aus Korrelation hervorgehenden Signalräume über weitere Korrelationen sowie mit aus der Wahrscheinlichkeitsrechnung bekannten Verfahren.

Es werden hier Verfahren der konditionalen Wahrscheinlichkeitsverarbeitung insofern als deterministisch betrachtet, als beispielsweise bei einem Signalraum, der aus genau zwei Untersignalräumen gebildet wird, von denen einer zur Gesamtmenge 60% beiträgt, der andere Signalraum dann 40% beiträgt.

Wesen des Verfahrens ist, über die gebildeten Signalräume und entsprechend deren Gehalt an Empfangsleistung- oder Energie, in Form eines Wahrscheinlichkeitsmaß, durch entsprechende Verknüpfungsverfahren den Gehalt an Empfangsleistung- oder Energie in einen oder mehreren Schnittgebietsraum bzw. -räumen entsprechend einer vorgebbaren Beobachtungsrichtung zu bestimmen.

Die Verknüpfung kann mit herkömmlichen Verfahren und Apparaturen ausgeführt werden, die die Erfordernisse zur kombinatorischen Logik oder Verknüpfung von Wahrscheinlichkeiten erfüllen. Ergebnis ist ein eindeutiges Wahrscheinlichkeitsmaß, welches gegen die über den Hauptsignalraum aufgenommene, absolute Empfangsleistung- oder Energie gewichtet werden kann.

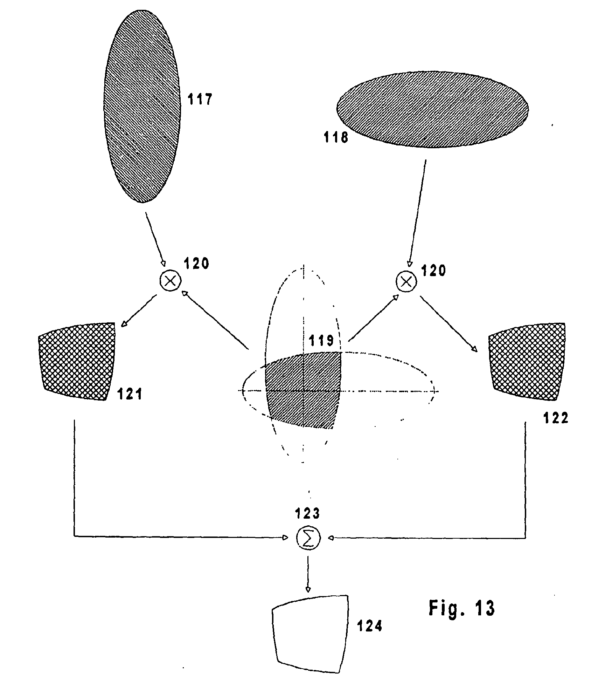

Ein Beispiel zu einer verknüpfenden Maßnahme ist, die gebildeten Fächer-Signalräume nochmals mit der Anzahl der jeweils zugehörigen Schnittgebiets-Signalräume zu korrelieren, was definitionsgemäß als Multiplikation ausgeführt werden kann. Fig. 13 zeigt ein Beispiel für eine Verknüpfung der Zwischenergebnisse aus nicht redundanten Hauptsignalräumen mit Mitteln der kombinatorischen Wahrscheinlichkeitsrechnung. Ein Schnittgebiets-Signalraum 119 wird einmal mit dem Strahlungsfächer-Signalraum 117 und ein weiteres mal mit dem Strahlungsfächer-Signalraum 118 multipliziert (120). Technisch kann diese Multiplikation durch eine Korrelation mit infinitesimal kleiner Integrationszeit ausgeführt werden. Die Strahlungsfächer-Signalräume 117, 118 sind bereits vorher aus entsprechenden Hauptsignalräumen und entsprechenden Strahlungsfächern generiert, die in Fig. 13 nicht dargestellt sind. Aus den Multiplikationen 120 resultieren Zwischenergebnisse (vgl. Bezugszeichen 121, 122), die summiert werden (vgl. Bezugszeichen 123) und das Endergebnis 124 zu einem Schnittgebiet liefern

Die Fig. 13 zeigt nur ein Beispiel für eine kombinatorische Wahrscheinlichkeitsverknüpfung zur Ergebnisfindung. Wesen und Anspruch dieses Teils des Verfahren ist, mit Mitteln der kombinatorischen Wahrscheinlichkeitsrechnung, beispielsweise entsprechend Fig.13, Verknüpfungen der gebildeten Strahlungsfächer-Signalräume 117, 118 mit dem gebildeten Schnittgebiets-Signalraum 119 in Bezug auf einen Hauptsignalraum zu schaffen. Grundsätzlich gilt:
a.) Die Strahlungsfächer-Signalräume 117, 118 sind ein Wahrscheinlichkeitsmaß dafür, welchen Beitrag die zu 117 und 118 gehörigen Strahlungsfächer zur vom entsprechenden Hauptsignalraum aufgenommenen Gesamtleistung- bzw. Energie liefern.
b) Der Schnittgebiets-Signalraum 119 ist ein Wahrscheinlichkeitsmaß dafür, welchen Beitrag das Schnittgebiet zu der von den es bildenden Strahlungsfächern aufgenommenen Gesamtleistung- bzw. Energie liefert. Das Wahrscheinlichkeitsmaß des Schnittgebiets-Signalraums kann gemäß Fig. 13 durch Korrelation bestimmt werden.
c) Mit bekannten Verfahren und technischen Vorrichtungen zur kombinatorischen Wahrscheinlichkeitsrechnung wird im ergebniszusammenführenden Teil des Verfahrens über Verknüpfungen abschließend ein Maß für die Wahrscheinlichkeit bestimmt, welchen Beitrag ein entsprechendes Schnittgebiet zur vom Hauptsignalraum aufgenommenen Gesamtleistung- bzw. Energie beiträgt.

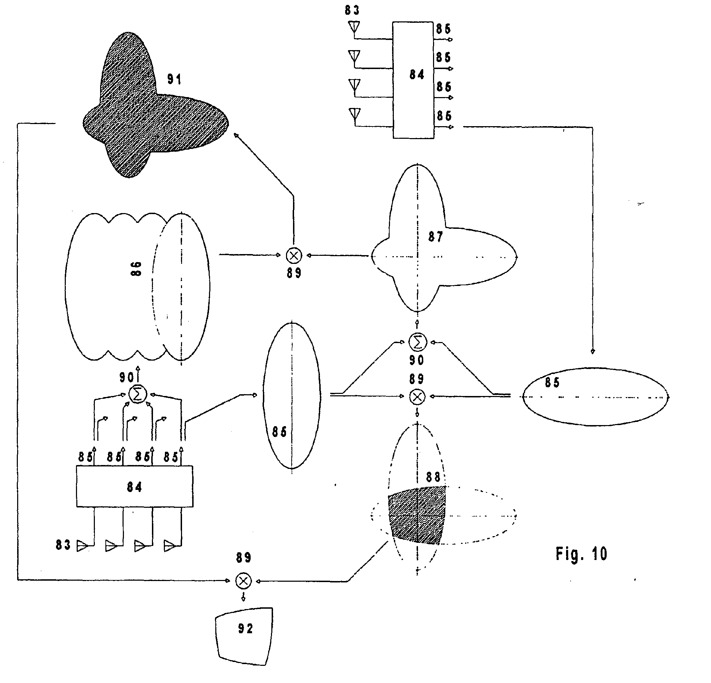

Das erfindungsgemäße Verfahren ermöglicht Abwandlungen, bei denen die Bildung von Unter- bzw. Hilfssignalräumen aus und zu einem Hauptsignalraum unter anderen jeglichen kombinatorischen Verknüpfungsmöglichkeiten vorgesehen ist. Ein Unter- bzw. Hilfssignalraum zu einem Hauptsignalraum kann beispielsweise dadurch gebildet werden, daß die an einem Schnittgebiet beteiligten Strahlungsfächer summenmäßig zusammengefaßt werden (Beispiel: Fig.10 Bezugszeichen 87).

Die Verknüpfungstechnik der in Zwischenergebnissen gewonnenen Wahrscheinlichkeitsmaße ist entsprechend den Erfordernissen der gewählten Hauptsignalraumkonfiguration zu wählen. Hieraus folgt, daß das Verfahren auch Anwendungen umfaßt, bei denen permutativ beliebige Untersignalräume geschaffen werden, die in Einzelschritten und hierzu notwendigen anderen Kombinationen letztendlich wieder zum gewünschten Ergebnis führen. Es ist ersichtlich, daß hieraus ebenfalls ein Wahrscheinlichkeitsmaß des Schnittgebiets in Bezug auf einen jeweiligen Fächer-Signalraum resultiert. Zur Findung des endgültigen Ergebnis können abschließend die ermittelten Wahrscheinlichkeitsmaße addiert werden. Es ergibt sich ein eindeutig definiertes Ergebnis über die zunächst relative Empfangsleistung- oder Energie in einem Schnittgebiet aus einem System abhängiger und nicht abhängiger Fächerräume.

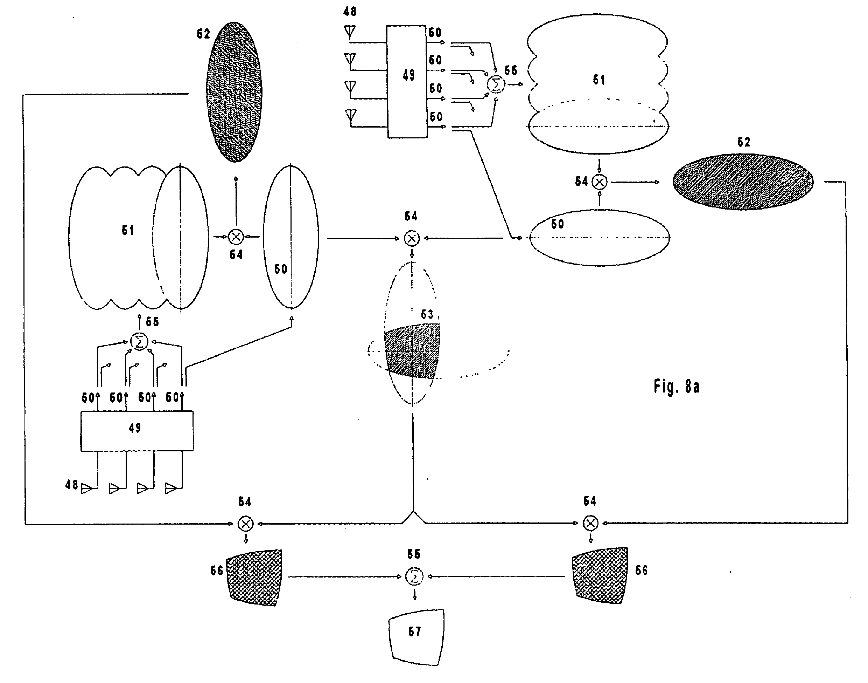

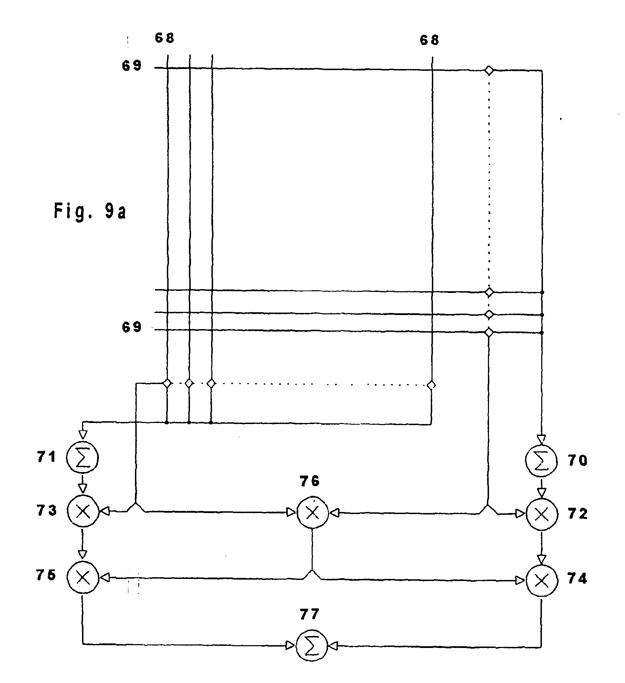

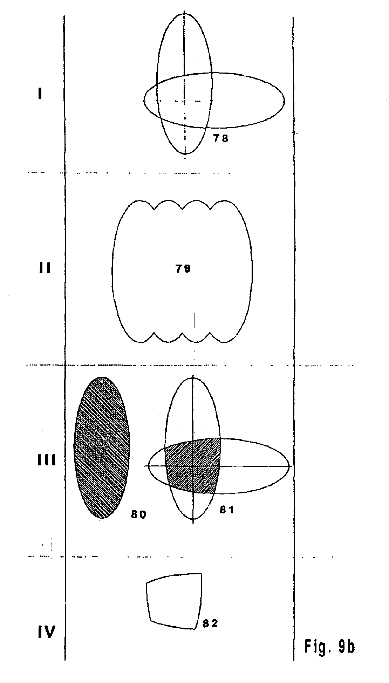

Ein Beispiel für die Durchführung des erfindungsgemäßen Verfahrens zeigen die Fig. 8a, 9a sowie 9b. Die Fig. 9a zeigt schematisch Verknüpfungen von Signalen zur Durchführung des Verfahrens gemäß Fig. 8a und Fig. 9b ein Fließbild des Verfahrensablaufs zu Fig. 8a.

Über eine Antennen- oder Sensoranordnung werden mit geeigneten Maßnahmen identische Strahlungsfächer bereitgestellt, die in x- und y- Richtung orthogonal aufeinanderstehen. Sowohl die Summe der horizontal angeordneten als auch die Summe der vertikal angeordneten Fächer überdecken im wesentlichen ein einziges gemeinsames Gesamtbeobachtungsgebiet. Aus dieser Anordnung kann ein nicht redundanter Hauptsignalraum aus den x-Fächern sowie ein dazu komplementärer, nicht redundanter Hauptsignalraum aus den y-Fächern gebildet werden. Jeweils alle x-Strahlungsfächer werden darauf gegen den x-Hauptsignalraum und alle y-Strahlungsfächer gegen den y-Hauptsignalraum korreliert, womit sich eine entsprechende Anzahl neuer Fächer-Signalräumen ergibt. Prinzipiell besteht auch die Möglichkeit, nur einen komplementären Teil des Hauptsignalraums zu bilden und auszuwerten.

Weiterhin werden alle x-Strahlungsfächer gegen alle y-Strahlungsfächer korreliert, was eine entsprechende Anzahl von Schnittgebiets-Signalräumen ergibt. Alle neu gewonnenen Schnittgebiets-Signalräume werden darauf nochmals gegen alle zum entsprechenden Schnittgebiet gehörenden und neu gewonnenen Fächer-Signalräume korreliert. Es ergibt sich eine entsprechende Anzahl von Korrelationswerten für die x-Fächer-Signalräume sowie für die y-Fächer-Signalräume, welche letztendlich entsprechend ihrer Zugehörigkeit zu einem jeweiligen Schnittgebiet, aufaddiert werden.

Im einzelnen zeigt Fig. 8a die Funktion des Verfahrens am Beispiel einer Version mit komplementären, nicht redundanten Hauptsignalräumen 51. Dargestellt sind im Beispiel zwei Systeme mit sich gegenseitig orthogonal durchdringenden Strahlungsfächern 50. Die Anordnung der Strahlungsfächer 50 relativ zueinander kann ansonsten aber auch in anderer als orthogonaler Form gewählt werden, beispielsweise in einem beliebigen Winkel relativ zueinander. Aus entsprechenden Antennen- bzw. Sensorzeilen 48 und Strahlungsfächer formenden Vorrichtungen 49 werden die Strahlungsfächer 50 gebildet, die durch Zusammenführung bzw. Summation 55 jeweils die Hauptsignalräume 51 bilden. Durch Korrelation 54 der Hauptsignalräume 51 mit den Strahlungsfächern 50 ergeben sich Strahlungsfächer-Signalräume 52. Durch Korrelation 54 entsprechender Strahlungsfächer 50 ergeben sich Schnittgebiets-Signalräume 53. Durch Multiplikation bzw. Korrelation 54 der entsprechenden Strahlungsfächer-Signalräume 52 mit den zugehörigen Schnittgebiets-Signalräumen 53 ergeben sich die Zwischenergebnisse 56, welche durch Summation 55 das eindeutige Ergebnis 57 zu einem Schnittgebiet liefern. Die Zwischen-: ergebnisse (vgl. Bezugszeichen 56) und die zugehörigen, zu ihrer Bildung ausgeführten Operationen sind Verfahrensteil zur nachfolgenden kombinatorischen Verknüpfung der Strahlungsfächer- bzw. Schnittgebiets-Signalräume.

Fig.9a zeigt eine Darstellung entsprechend der Fig.8a. Aus den Strahlungsfächern in Y-Richtung 68 wird durch Summation ein nicht redundanter Y-Hauptsignalraum 71 gebildet, der im Beispiel komplementär zum X-Hauptsignalraum 70 ist. Gleichfalls wird aus den Strahlungsfächern in X-Richtung 69 durch Summation ein nicht redundanter X-Hauptsignalraum 70 gebildet, der im Beispiel komplementär zum Y-Hauptsignalraum 71 ist. Durch Korrelation 73 des Y-Hauptsignalraumes 71 mit einem Y-Strahlungsfächer 68 ergibt sich ein Y-Strahlungsfächer-Signalraum 73. Entsprechend ergibt sich durch Korrelation 72 des X-Hauptsignalraums 70 mit einem X-Strahlungsfächer 69 ein X-Strahlungsfächer-Signalraum 72. Weiterhin ergibt sich durch Korrelation 76 eines Y-Strahlungsfächers 68 mit einem X-Strahlungsfächer 69 ein Schnittgebiets-Signalraum 76. Das Ergebnis dieses Schnittgebiets-Signaraums 76 wird mit dem Ergebnis des Y-Strahlungsfächer-Signalraums 73 zum Y-Zwischenergebnis 75 multipliziert bzw. korreliert. Analog wird das Ergebnis des Schnittgebiets-Signalraums 76 mit dem Ergebnis des X-Strahlungsfächer-Signalraums 72 zum X-Zwischenergebnis 74 multipliziert bzw. korreliert. Es folgt abschließend die Ergebnisbildung durch Zusammenführung bzw. Summation 77 der X- und Y-Zwischenergebnisse 74, 75 zu einem eindeutigen Ergebnis in Bezug auf die Vergleichbarkeit mit anderen und gleichermaßen behandelten Schnittgebieten. Für jedes gewünschte Schnittgebiet kann ein entsprechendes Ergebnis ermittelt werden.

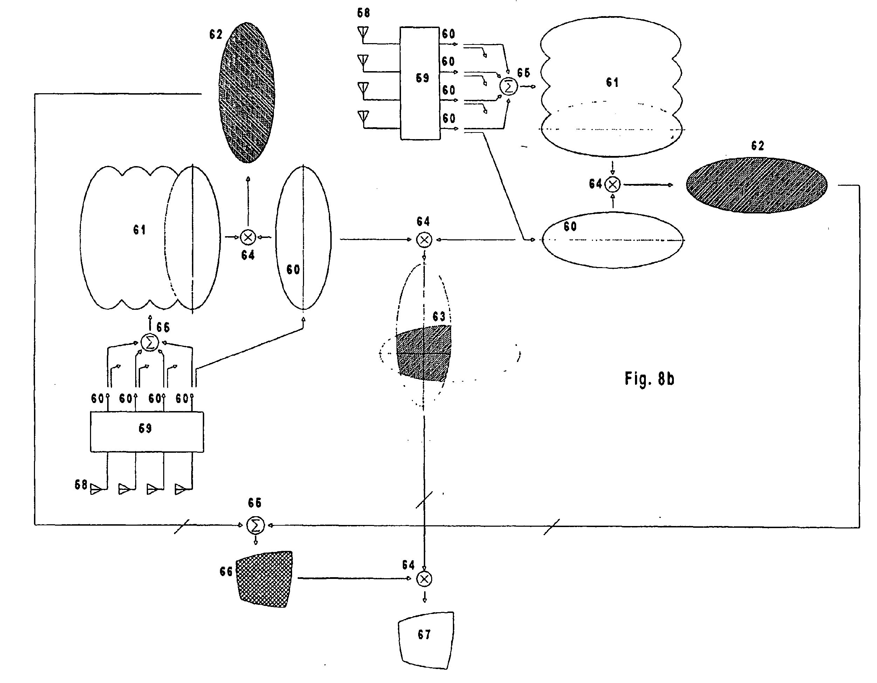

Fig.9b zeigt ein Fließbild des Ablaufes des Verfahrens nach Fig.8. Die aufsteigende römische Ziffernfolge I - IV gibt in Fig. 9b die Reihenfolge im Ablauf des Verfahrensfluß an.

In Schritt I erfolgt zunächst die Vorgabe einer nicht gefüllten Apertur aus einer Anzahl sich in vorgebbarer Geometrie und/oder Verteilung durchdringender Strahlungsfächer 78. Es erfolgt unter Bezugszeichen 78 die Bildung von vorzugsweise mehreren, jedoch mindestens einem Schnittgebiet. In Schritt II erfolgt die Erzeugung eines geeigneten und wählbaren Hauptsignalraums 79 (redundant oder nicht redundant sowie komplementär, graduell komplementär oder nicht komplementär).

In Schritt III erfolgt durch Korrelation die Feststellung, in welchem Maß jeder Strahlungsfächer zur vom Hauptsignalraum aufgenommenen bzw. diesem zugeordneten Gesamtleistung- oder Energie beiträgt. Ergebnis ist ein Fächer-Signalraum 80. Gleichfalls in Schritt III erfolgt durch Korrelation die Feststellung, in welchem Maß jedes Schnittgebiet zur von den das Schnittgebiet bildenden Strahlungsfächern aufgenommenen bzw. diesen zugeordneten Leistung- oder Energie beiträgt. Ergebnis ist ein Schnittgebiets-Signalraum 81.

In Schritt IV erfolgt die Verknüpfung der Zwischenergebnisse durch Korrelationen bzw. Multiplikationen und/oder Summationen und/oder Mittel der kombinatorischen Wahrscheinlichkeitsrechnung zur Feststellung, in welchem Maß ein Schnittgebiet zur vom Hauptsignalraum aufgenommenen bzw. diesem zugeordneten Gesamtleistung bzw. -energie beiträgt. Das Ergebnis zu Bezugszeichen 82 ist eindeutig und macht alle derart behandelten Schnittgebiete bzw. Messungen in diese entsprechenden Beobachtungsrichtungen vergleichbar.

Das Verfahren umfaßt auch die Fälle, welche andere Aufteilungen oder Hilfszusammensetzungen der Signalräume (Hilfssignalräume) in anderen Unterteilungsschritten mit der gleichen Ergebnisfindung zuläßt.

Fig.8b zeigt eine Darstellung des erfindungsgemäßen Verfahrens ähnlich zu Fig.8a, jedoch mit einer anderen Verknüpfung der Zwischenergebnisse. Für die Verknüpfung sind alle sinnvollen Kombinationen möglich, die die Zwischenergebnisse bzw. die Strahlungsfächer entsprechend deren Anteil an Gesamtheiten von Leistungs- bzw. Energiepegeln zusammenfügen.

Entsprechend zu Fig. 8a zeigt Fig. 8b, wie aus entsprechenden Antennen- bzw. Sensorzeilen 58 und Strahlungsfächer formenden Vorrichtungen 59 Strahlungsfächer gebildet werden, aus denen wiederum durch Zusammenführung bzw. Summation 65 jeweils Hauptsignalräume 61 gebildet werden. Durch Korrelation 64 der Hauptsignalräume 61 mit den Strahlungsfächern 60 ergeben sich Strahlungsfächer-Signalräume 62. Durch Korrelation 64 entsprechender Strahlungsfächer 60 ergeben sich Schnittgebiets-Signalräume 63. Der nun folgende Verknüpfungsteil läuft in Fig. 8b in der Weise ab, daß zunächst die Strahlungsfächer-Signalräume 62 durch Summation 65 zum Zwischenergebnis 66 zusammengefaßt werden. Der Signalraum des Zwischenergebnisses 66 wird darauf mit dem zugehörigen Schnittgebiets-Signalraum 63 multipliziert bzw. definitionsmäßig korreliert, was das Ergebnis 67 zu einem Schnittgebiet liefert. Gegenüber Fig. 8a ist in Fig. 8b somit der Ablauf einer anderen möglichen Verknüpfungsvariante gezeigt.

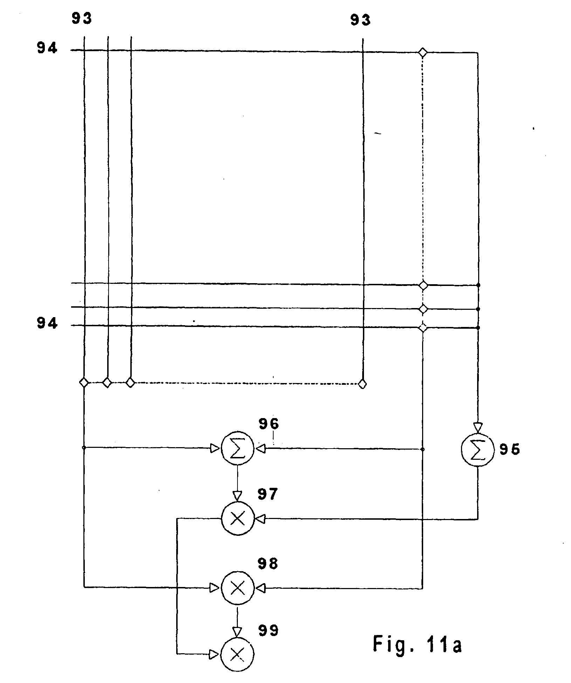

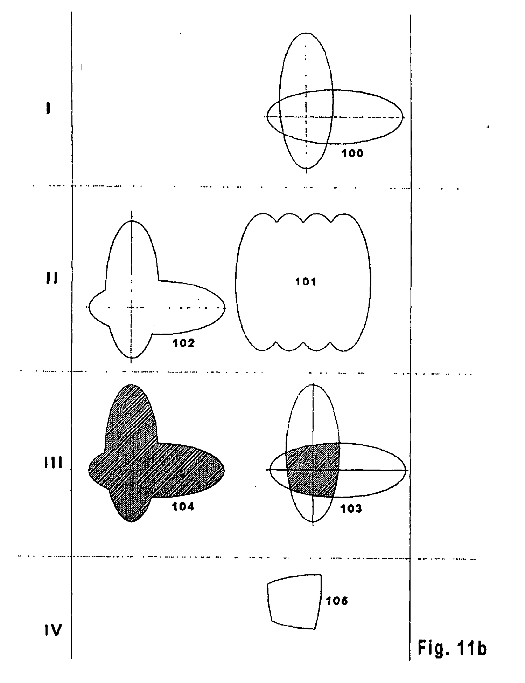

Die Fig. 10, Fig. 11a und Fig. 11b zeigen eine Variante des Verfahrens, das nur einen Hauptsignalraum zur Auswertung benutzt und die an einem Schnittgebiet beteiligten Fächer, beispielsweise aus X- und Y-Richtung, in einem Unter- bzw. Hilfssignalraum zusammenfaßt, der darauf in zusammengesetzter Form gegen den Hauptsignalraum korreliert wird. Ergebnis ist ein korrelierter Unter- bzw. Hilfssignalraum. Die Zusammensetzung des Untersignalraums erfolgt nach den Regeln zur Bildung eines Hauptsignalraums. Bei Auswertung eines Hauptsignalraums können sowohl redundante wie auch nicht redundante Hauptsignalräume herangezogen werden. Die kombinatorische Verknüpfung ist entsprechend den Erfordernissen der Signalraum-Konfigurationen aus gängigen Verfahren wählbar. Fig. 10, Fig. 11a und Fig.11b sind Beispiel für eine Kombination mit Bildung und Unterteilung in Unter- bzw. Hilfssignalräume.

Im Beispiel der Fig. 10 sind zwei Systeme mit sich gegenseitig orthogonal durchdringenden Strahlungsfächern 85 dargestellt. Die Anordnung der Strahlungsfächer 85 kann jedoch auch in anderer als orthogonaler Form gewählt werden. Aus entsprechenden Antennen- bzw. Sensorzeilen 83 und Strahlungsfächer formenden Vorrichtungen 84 werden die Strahlungsfächer 85 gebildet. Jedoch wird in Fig. 10 nur ein einziger Hauptsignalraum 86 durch Summation 90 der Strahlungsfächer 85 aus entweder dem X-Teil oder dem Y-Teil einer Antennen- bzw. Sensoranordnung 83 bzw. Strahlformungsvorrichtung 84 erzeugt. Neben dem Hauptsignalraum 86 wird weiterhin und ebenfalls nach den Regeln zur Bildung von Hauptsignalräumen, ein Unter- bzw. Hilfssignalraum 87 durch Zusammenführung bzw. Summation 90 entsprechend gewählter Strahlungsfächer 85 gebildet. Durch Korrelation 89 des Unter- bzw. Hilfssignalraums 87 mit dem Hauptsignalraum 86 ergibt sich ein korrelierter Untersignalraum 91. Der korrelierte Untersignalraum 91 stellt ein Wahrscheinlichkeitsmaß dar, welchen Beitrag der Untersignalraums 87 zur vom Hauptsignalraum 86 aufgenommenen Gesamtleistung- bzw. Energie leistet. Durch Korrelation 89 zweier entsprechender Strahlungsfächer 85 wird ein Schnittgebiets-Signalraum 88 gebildet, der ein Wahrscheinlichkeitsmaß dafür ist, welchen Beitrag das Schnittgebiet zur von den am Schnittgebiet beteiligten Strahlungsfächer 85 aufgenommenen Gesamtleistung bzw. -energie liefert.

Durch Multiplikation bzw. definitionsgemäß Korrelation werden die Zwischenergebnisse aus dem korrelierten Untersignalraum 91 und dem Schnittgebiets-Signalraum 88 zum Ergebnis 92 verknüpft.

Fig. 11a zeigt schematisch Verknüpfungen von Signalen zur Durchführung des Verfahrens gemäß Fig.10. Aus den Strahlungsfächern in X-Richtung 94 wird durch Summation 95 ein nicht redundanter X-Hauptsignalraum 95 gebildet (Anmerkung: Das Beispiel hätte für einen redundanten Hauptsignalraum Gültigkeit, wenn zu Bezugszeichen 95 die X-Strahlungsfächer 94 (x1,x2,...,xn) und Y-Strahlungsfächer 93 (y1,y2,...yn) als zusammengefaßter bzw. aus diesen zusammengesetzter Hauptsignalraum vorliegen würden). Neben dem nicht redundanten Hauptsignalraum 95 wird weiterhin und ebenfalls nach den Regeln zur Bildung von Hauptsignalräumen durch Zusammenführung bzw. Summation 96 entsprechend gewählter X-Strahlungsfächer 94 und Y-Strahlungsfächer 93, ein Untersignalraum 96 gebildet. Durch Korrelation 97 des Untersignalraumes 96 mit dem Hauptsignalraum 95 ergibt sich der korrelierte Untersignalraum 97. Weiterhin ergibt sich durch Korrelation 98 eines Y-Strahlungsfächers 93 mit einem X-Strahlungsfächer 94 ein Schnittgebiets-Signalraum 98. Als abschließender Verknüpfungsteil folgt die Ergebnisbildung 99 durch Multiplikation bzw. Korrelation des korrelierten Untersignalraumes 97 mit dem Schnittgebiets-Signalraum 98 zu einem eindeutigen Ergebnis in Bezug auf die Vergleichbarkeit mit anderen und gleichermaßen behandelten Schnittgebieten. Für jedes gewünschte Schnittgebiet kann ein Ergebnis gemäß Bezugszeichen 99 ermittelt werden.

Fig.11b zeigt ein Fließbild des Ablaufs des Verfahrens entsprechend den Ausführungen zu Fig.10 mit einem aus Strahlungsfächern gebildeten Unter- bzw. Hilfssignalraum. Die aufsteigende römische Ziffernfolge I - IV gibt in Fig.11b die Reihenfolge im Ablauf des Verfahrensfluß an.

In Schritt I erfolgt zunächst die Vorgabe einer nicht gefüllten Apertur aus einer Anzahl sich in vorgebbarer Geometrie und/oder Verteilung durchdringender Strahlungsfächer 100. Es erfolgt unter Bezugszeichen 100 desgleichen die Bildung-von vorzugsweise mehreren, mindestens jedoch einem Schnittgebiet.

In Schritt II erfolgt die Erzeugung eines geeigneten und wählbaren Hauptsignalraums 101 (redundant oder nicht redundant; sowie komplementär, graduell komplementär oder nicht komplementär). Gleichfalls in Schritt II erfolgt die Bildung eines Unter- bzw. Hilfssignalraums 102 durch Zusammenfassung bzw. Summation von an einem Schnittgebiet beteiligter Strahlungsfächer. Die Zusammenfassung zu einem Unter- bzw. Hilfssignalraum 102 erfolgt entsprechend den Regeln zu einem Hauptsignalraum.

In Schritt III erfolgt durch Korrelation die Feststellung, in welchem Maß jedes Schnittgebiet zur von den es bildenden Strahlungsfächern aufgenommenen Leistung oder -energie beiträgt. Zwischenergebnis ist ein Schnittgebiets-Signalraum 103. Weiterhin erfolgt in Schritt III durch Korrelation die Feststellung, in welchem Maß jeder Unter- bzw. Hilfssignalraum zur vom Hauptsignalraum aufgenommenen Gesamt-leistung- oder Energie beiträgt. Zwischenergebnis ist ein korrelierter Unter- bzw. Hilfssignalraum 104.

Im abschließenden Schritt IV erfolgt die Verknüpfung der Zwischenergebnisse durch Korrelation bzw. Multiplikation und/oder Summation und/oder Mittel der kombinatorischen Wahrscheinlichkeitsrechnung zur Feststellung, in welchem Maß ein Schnittgebiet zur vom Hauptsignalraum aufgenommenen Gesamtleistung bzw. -energie beiträgt. Das Ergebnis zu Bezugszeichen 105 ist eindeutig und macht alle derart behandelten Schnittgebiete bzw. Messungen in diese Beobachtungsrichtungen vergleichbar.

Das Verfahren umfaßt auch die Fälle, welche andere Aufteilungen oder Hilfszusammensetzungen der Signalräume in anderen Unterteilungsschritten mit der gleichen Ergebnisfindung zuläßt.

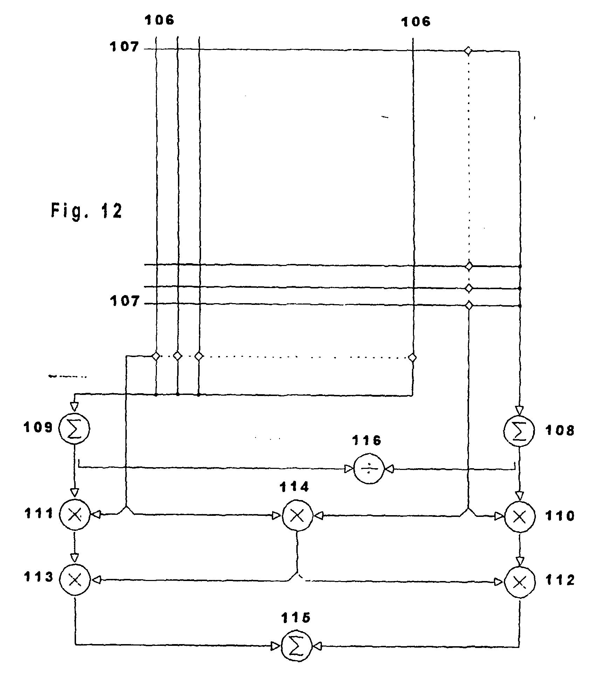

Fig.12 zeigt schematisch Verknüpfungen von Signalen ähnlich zu Fig.9a, jedoch mit der Option zur Verarbeitung nicht ideal komplementärer, nicht redundanter Hauptsignalräume bzw. nur graduell komplementärer Hauptsignalräume. Aus den Strahlungsfächern in Y-Richtung 106 wird durch Summation 109 ein nicht redundanter Y-Hauptsignalraum 109 gebildet, der im Beispiel nur graduell komplementär zum X-Hauptsignalraum 108 ist. Gleichfalls wird aus den Strahlungsfächern in X-Richtung 107 durch Summation 108 ein nicht redundanter X-Hauptsignalraum 108 gebildet, der im Beispiel nur graduell komplementär zum Y-Hauptsignalraum 109 ist. Durch Korrelation 111 des Y-Hauptsignalraumes 109 mit einem Y-Strahlungsfächer 106 ergibt sich ein Y-Strahlungsfächer-Signalraum 111. Entsprechend ergibt sich durch Korrelation 110 des X-Hauptsignalraumes 108 mit einem X-Strahlungsfächer 107 ein X-Strahlungsfächer-Signalraum 110. Weiterhin ergibt sich durch Korrelation 114 eines Y-Strahlungsfächers 106 mit einem X-Strahlungsfächer 107 ein Schnittgebiets-Signalraum 114. Das Ergebnis dieses Schnittgebiets-Signalraumes 114 wird mit dem Ergebnis des Y-Strahlungsfächer-Signalraums 111 zum Y-Zwischenergebnis 113 multipliziert bzw. korreliert. Analog wird das Ergebnis des Schnittgebiets-Signalraumes 114 mit dem Ergebnis des X-Strahlungsfächer-Signalraumes 110 zum X-Zwischenergebnis 112 multipliziert bzw. korreliert.

Option ist die zusätzliche Bestimmung des Verhältnisses 116 zwischen der jeweiligen, über den nicht redundanten X-Hauptsignalraum 108 und nicht redundanten Y-Hauptsignalraum 109 aufgenommenen Gesamtleistung bzw. Energie im Fall nicht vollständiger oder nicht idealer Komplementät beider Hauptsignalräume 108,109. Die Verhältnisbildung 116 erfolgt beispielsweise durch Division der über den X-Hauptsignalraum aufgenommenen Gesamtleistung- bzw. Energie und der über den Y-Hauptsignalraum aufgenommenen Gesamtleistung- bzw. Energie. Die Verhältnisbildung 116 gründet sich darauf, daß über den nicht redundanten Hauptsignalräumen ad hoc kein Signalraum mehr existiert. Führt man beispielsweise als Summation die nicht redundanten X- und Y-Hauptsignalräume zusammen, dann würde dies nunmehr einem redundanten Hauptsignalraum entsprechen. Mithin existieren über den nicht redundanten Hauptsignalräumen keine weiteren nicht redundanten Hauptsignalräume. Das Ergebnis der Verhältnisbildung führt eine Wichtung ein, die in entsprechendem Fall in der Verknüpfung bzw. den Operationen zu den Bezugszeichen 108, 109, 110, 111, 112 , 113 nach sinngemäßer Wahl, zu berücksichtigen ist. Die Option ist sinnvoll auf nicht redundante Hauptsignalräume oder auch auf Unter- bzw. Hilfssignalräume anwendbar.

Es folgt die Ergebnisbildung als abschließender Verknüpfungsteil durch Zusammenführung bzw. Summation 115 der bereits mittels Verhältnisbildung 116 gewichteten X- und Y-Zwischenergebnisse 112, 113 zu einem eindeutigen Ergebnis in Bezug auf die Vergleichbarkeit mit anderen und gleichermaßen behandelten Schnittgebieten. Für jedes gewünschte Schnittgebiet kann ein Ergebnis gemäß 115 ermittelt werden.

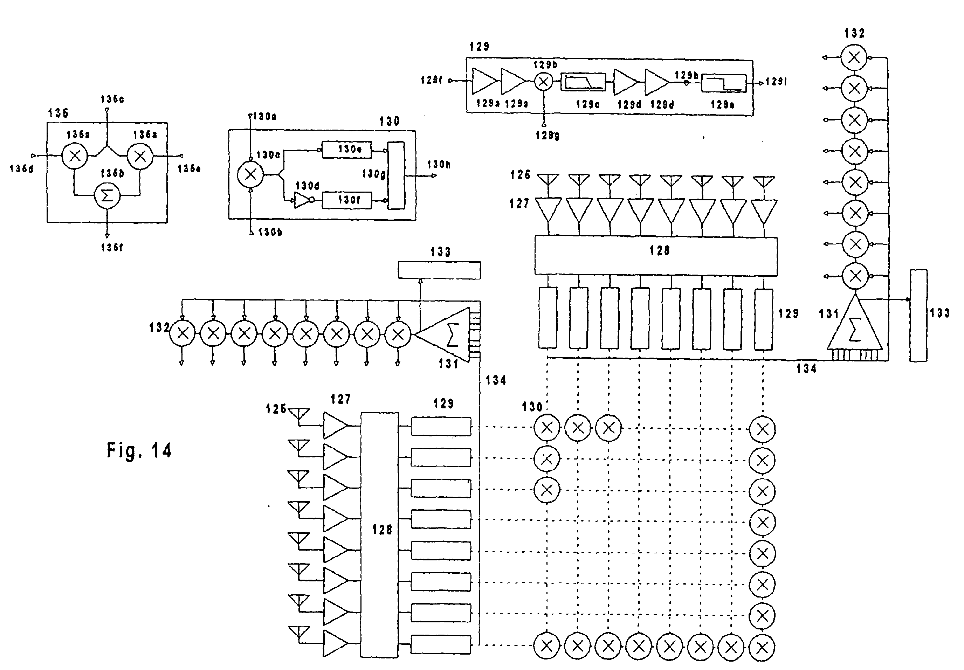

Fig.14 zeigt das Blockdiagramm eines Ausführungsbeispieles einer erfindungsgemäßen Vorrichtung zur Durchführung des erfindungsgemäßen Verfahrens, insbesondere des im Zusammenhang mit Fig. 12 erläuterten Verfahrens. Die Vorrichtung besteht aus jeweils einer Antennenzeile 125 in X-Richtung und einer Antennenzeile 126 in Y-Richtung. Beide Antennenzeilen bilden eine orthogonale Antennenanordnung. Auf jede Einzelantenne folgt ein HF-Vorverstärker 127.

Zur Formung von jeweils acht Strahlungsfächern in X- sowie auch in Y-Richtung werden die Empfangssignale der X- bzw. Y-Antennenzeilen 125, 126 einer jeweils entsprechenden Butler-Matrix 128 zugeführt. Jeder Ausgang der X- bzw. Y-Butler Matrix führt auf jeweils einen zu jedem X- bzw. Y-Kanal gehörenden Empfänger 129. Das Eingangssignal 129a eines jeden Empfängers 129 wird zunächst in weiteren HF-Verstärkerstufen 129a weiter verstärkt. Es folgt ein Mischer 129b, der die Signale direkt in das Basisband mischt. Handelt es sich wie im Beispiel um rauschverteilte Signale, können diese um die Frequenz Null gefaltet werden. Das Oszillatorsignal wird gemäß Bezugszeichen 129g zugeführt.

Auf den Mischer 129b folgt ein Tiefpaßfilter 129c sowie darauf weitere Basisbandverstärker 129d. Am Ausgang der Basisbandverstärker 129d steht das Basisbandsignal 129h zur folgenden digitalen Quantisierung bereit. Ein wesentlicher Vorteil des erfindungsgemäßen Verfahrens besteht darin, daß die Auswertung mit reduzierter Quantisierung, bis hin zu 1-Bit-wertiger Quantisierung erfolgen kann. Da die Korrelation ein statistisches Maß liefert, braucht nicht notwendigerweise eine Quantisierung des Signals in maximale bitwertige Auflösung über beispielsweise den vollständigen bitwertigen Dynamikbereich eines sogenannten ADC (Analog-Digital-Converter) vorgenommen werden, um die gewünschte Auflösung des aufgenommenen Empfangsleistungs- oder Energiepegels zu erzielen.

Die Vorrichtung gemäß Fig. 14 quantisiert das Basisbandsignal 129h 1-Bit wertig nach Vorzeichen in einem Nulldurchgangsdetektor 129e. Ausgangssignal eines jeden Empfängers ist ein 1-Bit-wertig quantisiertes Signal 129i. Jeder Ausgang eines der Empfänger 129 entspricht einem zur X- oder Y-Antennezeile gehörenden Strahlungsfächer, der dann auf einer Signalleitung 134 weitergeführt wird. Die X- bzw. Y-Signalleitung 134 führt jeweils auf einen Addierer 131 mit acht Eingängen, welcher die Strahlungsfächer zu jeweils einem nicht redundanten X-Hauptsignalraum bzw. einem nicht redundanten Y-Hauptsignalraum zusammenfaßt. Zum Zweck der gegenseitigen Korrelation wird, wie auch jeder Strahlungsfächer, jeder Hauptsignalraum durch eine 1-Bit-quantisierte, zeitliche Signalfolge am Ausgang der Addierer 131 dargestellt. Optional kann jeweils mit einem Analog-Digital-Wandler 133 die absolute Gesamtleistung bzw. -energie im entsprechenden X- bzw. Y-Hauptsignalraum bestimmt werden. Das Verhältnis der beiden absoluten Werte der Hauptsignalräume normiert bzw. wichtet die Hauptsignalräume gegeneinander. Die gesamte Vorrichtung benötigt bei zwei Hauptsignalräumen unabhängig von der gesamten Fächerzahl lediglich zwei Analog-Digital-Wandler zur absoluten Skalierung der Meßwerte. Die Eindeutigkeit zu jedem Schnittgebiet und die Vergleichbarkeit kann die Apparatur jedoch aber auch ohne Analog-Digital-Wandler und in relativer Form bestimmen.

Weiterhin wird jeder X-Empfängerausgang mit jedem Y-Empfängerausgang in einem 1-Bit-Korrelator 130, korreliert. Ergebnis sind im Beispiel insgesamt vierundsechzig Schnittgebiets-Signalräume. Die Korrelation läuft in der Art ab, daß beispielsweise das Signal eines X-Strahlungsfächers am Korrelatoreingang 130a und das Signal eines Y-Strahlungsfächers am Korrelatoreingang 130b anliegt. Die digitale 1-Bit-Korrelation bzw. -multiplikation der X- und Y-Signalfolge erfolgt mittels eines Exklusiv-Oder-Gatters 130c. Zum einen führt das Exklusiv-Oder Gatter 130c auf einen Aufwärtszähler 130e, welcher um eins erhöht, wenn die Exklusiv-Oder-Aussage wahr ist. Zum anderen führt das Exklusiv-Oder-Gatter 130c auf die Kombination aus einem Inverter 130d und einem Aufwärtszähler 130f, welcher um eins erhöht, wenn die Exklusiv-Oder-Aussage nicht wahr ist. Würden beispielsweise an beiden Eingängen 130a, 130b identische Signale mit identischer Vorzeichenfolge anliegen, dann wäre die Exklusiv-Oder-Aussage, je nach Definitionsrichtung beispielsweise immer wahr und nur der Aufwärtszähler 130e würde erhöhen. Nach vorgegebener Summationszahl, entsprechend einer Integrationszeit, erfolgt eine Differenzbildung 130g zwischen beiden Aufwärtszählerständen. Der Ausgang 130h liefert ein Wahrscheinlichkeitsmaß dafür inwieweit ein jeweiliger X-Strahlungsfächer mit einem jeweiligen Y-Strahlungsfächer korreliert ist. Die "Integrationszeit" ist unter Berücksichtigung der gewählten Bandbreite im apparativen Aufbau entsprechend wählbar. Durch Korrelation 132 der X- bzw. Y-Strahlungsfächer mit den zugehörigen Hauptsignalräumen werden im Beispiel insgesamt sechzehn Strahlungsfächer-Signalräume entsprechenden Korrelatoren 130, gebildet. Die entsprechenden Korrelationsvor gänge können apparativ direkt aufeinanderfolgen.

Durch kombinatorische Verknüpfung der gemäß mit Bezugszeichen 130 und 132 bereitgestellten Ausgänge ergibt sich als Ergebnis ein Maß darüber, welchen Beitrag ein entsprechendes Schnittgebiet zur über alle Fächer aufgenommenen Gesamtleistung- bzw. Energie leistet. Die Verknüpfung 135 läuft bei der Vorrichtung gemäß Fig. 14 in der Weise ab, daß einmal das Signal des am Eingang 135c anliegenden Schnittgebiets-Signalraumes 130 mit dem am Eingang 135d anliegenden Signal des X-Strahlungsfächer-Signalraums 132 und einmal mit dem am Eingang 135e anliegenden Signal des Y-Strahlungsfächer-Signalraumes 132, multipliziert 135a wird. Die beiden Multiplikationsergebnisse werden zusammengeführt bzw. summiert 135b und liefern am Ausgang 135f das Ergebnis zu einem Schnittgebiet bzw. zu einer bestimmten Beobachtungsrichtung.

Das Verfahren umfaßt auch diejenigen Varianten, in denen beispielsweise die Strahlungsfächer, ensprechend Fig. 10, zu Untersignalräumen zusammengefaßt werden oder Hauptsignalräume in Untersignalräume aufgeteilt werden.

Ziel des Verfahrens ist, aus einer gegebenen Fächeranzahl einen Hauptsignalraum zu bilden und hieraus das Maß zu bestimmen, inwieweit jeder einzelne Fächer zur Gesamtheit der aufgenommenen Empfangsleistung oder -energie beiträgt. Ist dies für jeden Fächer bekannt, dann wird durch Korrelation von einzelnen Fächern ein Schnittgebiet gebildet, welches wiederum angibt, welchen Teil das Schnittgebiet zur aufgenommenen Empfangsleistung oder -energie der nunmehr am Schnittgebiet beteiligten Fächer beiträgt. Durch Verknüpfung der so gebildeten Zwischenergebnisse wird dann bestimmt, welchen Teil das Schnittgebiet zum ganzen Hauptsignalraum beiträgt. Dieser Verfahrensgang führt in beliebig variierbaren Schrittfolgen oder Aufteilungen in abgewandelten Hilfs- bzw. Untersignalräume zum gleichen Ergebnis, die Empfangsleistung oder -energie zu jedem Schnittgebiet und damit zu einer vorgebbaren Beobachtungsrichtung konfusionsfrei, d. h. frei von Mehrdeutigkeiten, die von aus anderen Richtungen einfallenden Signalen herrühren können, zu bestimmen. Hierbei sind auch Unter- und Hilfsaufteilungen der Signalräume sowie deren permutative Verknüpfungen möglich.

Herausragende Eigenschaft des neuen Verfahrens ist die Möglichkeit zu sehr hohen Verarbeitungsgeschwindigkeiten aufgrund reduzierter Quantisierung. Da die Korrelationen ein statistisches Maß in Form einer Varianz liefert, braucht keine Quantisierung des Signals in maximale bitwertige Auflösung über beispielsweise den bitwertigen Dynamikbereich eines sogenannten ADC (Analog-Digital-Converter) vorgenommen werden, um die gewünschte Auflösung des aufgenommenen Empfangsleistungs- oder Energiepegels zu erzielen. Trotz Beibehaltung einer im Endergebnis gewünschten Auflösung über den Empfangspegel reicht im Verfahrensablauf eine reduzierte Quantisierung bis hin zu einer Bit-wertigen Quantisierung aus. Beispiel einer 1-Bit-wertigen Korrelation ist eine Vorzeichenkorrelation. Die zeitliche Signalfolge wird hierbei nach dem Vorzeichen bzw. der Polarität des Signals quantisiert. Beispielsweise ein sogenanntes Exklusiv-Oder-Gatter ist geeignet, die Multiplikation von 1-Bit-wertigen Signalfolgen auszuführen. Eine Integration der Multiplikationsergebnisse über die Zeit kann in der Art erfolgen, daß jeweils alle logisch wahren Exklusiv-Oder-Gatter Ereignisse und alle logisch unwahren Exklusiv-Oder-Ereignisse über die gewählte Integrationszeit getrennt aufsummiert werden. Nach Ablauf der Integrationszeit wird die Anzahl der logisch unwahren Ereignisse von der Anzahl der logisch wahren Ereignisse abgezogen, was dann dem Korrelationsergebnis entspricht.

Folgen im Verfahren mehrere Korrelationen aufeinander, so können die Multiplikationen definitionsgemäß auch aufeinanderfolgend ausgeführt werden und erst bei Bedarf eine Integrationszeit am Ende des Verfahrensablauf ausgeführt werden. Das ereignissummierende Integrationsverfahren mit 1-Bit-wertiger Korrelation ermöglicht es darüber hinaus, auch die letztendliche Summation der beiden Korrelationswerte kombiniert auszuführen.

Das erfindungsgemäße Verfahren führt keinen strahlformenden Prozeß in der Art aus, wie dieser im strengen Sinne, beispielsweise in Form vektorieller Summation, definiert ist. Die Richtungsauflösung erfolgt im wesentlichen nach wie vor durch die bekannten oben beschriebenen Verfahren. Das Verfahren löst demgegenüber jedoch die Mehrdeutigkeiten auf, welche über die einzelnen Fächerdiagramme des Systems in Form nicht aus Beobachtungsrichtung kommender Signale oder Störquellen aufgenommen werden. Die Vorrichtung ist in der Lage, Signale richtungsmäßig zu bewerten, die anliegende, gesamte Empfangssignalleistung oder Energie wird vom System jedoch auch aufgenommen und muß von diesem pegelmäßig vollständig verarbeitet werden.

Das Verfahren sieht Anwendungen wie beispielsweise in radioastronomischen, RIO(Relative Ionospheric Opacity)-metrischen oder radiometrischen Instrumenten vor, bei denen gleichzeitig in einer vorgebbaren Anzahl von Richtungen oder Richtungsbestimmungen, konfusionsfreie und eindeutige Messungen oder Auswertungen der aufgenommenen Empfangsleistung oder Empfangsenergie vorgenommen werden.

Das Verfahren sieht desgleichen Anwendungen in Fernmelde-, Ortungs- und Aufklärungssystemen vor, bei denen ebenfalls gleichzeitig in einer vorgebbaren Anzahl von Richtungen oder Richtungsbestimmungen, konfusionsfreie und eindeutige Messungen oder Auswertungen der aufgenommenen Empfangsleistung oder Empfangsenergie vorgenommen werden.

## Patentansprüche

**1.** Verfahren zur Bestimmung einfallender Empfangsleistung oder -energie oder anderer technischer Meßgrößen wenigstens eines Signales in wenigstens einer vorgebbaren Beobachtungsrichtung, mit folgenden Verfahrensschritten:
a) Erfassung eines einfallenden Signales mittels Sensormitteln,
b) Bildung von, einzelnen Sensoren, Gruppen von Sensoren oder Sensorbereichen der Sensormittel zugeordneten, Strahlungsfächern,
c) Bildung wenigstens eines Schnittgebietes zwischen wenigstens zwei Strahlungsfächern,
d) Bildung wenigstens eines Hauptsignalraumes, der die Form einer Anzahl von Strahlungsfächern und die diesen Strahlungsfächern zugeordnete Empfangsleistung oder -energie repräsentiert,
e) Auswahl wenigstens eines Schnittgebietes
f) Bestimmung eines Maßes für den Anteil jedes an der Bildung des ausgewählten Schnittgebietes beteiligten Strahlungsfächers an der dem Hauptsignalraum zugeordneten Gesamtempfangsleistung oder -energie,
g) Bestimmung eines Maßes für den dem ausgewählten Schnittgebiet zugeordneten Anteil an der Empfangsleistung oder -energie, die den an der Bildung des Schnittgebietes beteiligten Strahlungsfächern zugeordnet ist und
h) Verknüpfung der in Schritt f) und g) erhaltenen Maße zur Bildung eines Maßes für den Anteil der in der vorgegebenen Beobachtungsrichtung einfallenden Empfangsleistung oder -energie an der dem Hauptsignalraum zugeordneten Gesamt-Empfangsleistung oder -energie.

**2.** Verfahren nach Anspruch 1, **dadurch gekennzeichnet, daß** das Maß für den Anteil jedes an der Bildung eines Schnittgebietes beteiligten Strahlungsfächers an der dem Hauptsignalraum zugeordneten Gesamtempfangsleistung oder -energie durch Korrelation des betreffenden Fächers mit dem Hauptsignalraum bestimmt wird.

**3.** Verfahren nach Anspruch 1 oder 2, **dadurch gekennzeichnet, daß** das Maß für den dem ausgewählten Schnittgebiet zugeordneten Anteil an der Empfangsleistung oder -energie, die den Strahlungsfächern, die dieses Schnittgebiet bilden, zugeordnet ist, durch Korrelation der an der Bildung des Schnittgebietes beteiligten Strahlungsfächer gebildet wird.

**4.** Verfahren nach einem der vorhergehenden Ansprüche, **dadurch gekennzeichnet, daß** die Strahlungsfächer wenigstens zwei, vorzugsweise mehr als zwei, Schnittgebiete bilden, derart, daß unterschiedliche Beobachtungsrichtungen durch Auswahl unterschiedlicher Schnittgebiete wählbar sind.

**5.** Verfahren nach einem der vorhergehenden Ansprüche, **dadurch gekennzeichnet, daß** wenigstens drei Strahlungsfächer ein räumliches Schnittgebiet bilden, das ein Beobachtungsgebiet bildet, derart, daß die aus dem Beobachtungsgebiet herrührende Empfangsleistung oder - energie bestimmbar ist.

**6.** Verfahren nach einem der vorhergehenden Ansprüche, **dadurch gekennzeichnet, daß** gleichzeitig in wenigstens zwei Beobachtungsrichtungen und/oder für wenigstens zwei Beobachtungsgebiete die einfallende Empfangsleistung oder -energie bestimmt wird.

**7.** Verfahren nach einem der vorhergehenden Ansprüche, **dadurch gekennzeichnet, daß** die dem Hauptsignalraum zugeordnete Gesamt-Empfangsleistung oder -energie oder ein Maß für diese Gesamt-Empfangsleistung oder -energie bestimmt wird.

**8.** Verfahren nach einem der vorhergehenden Ansprüche, **dadurch gekennzeichnet, daß** der Hauptsignalraum entsprechend der Form von Strahlungsfächern und der diesen Strahlungsfächern zugeordneten Empfangsleistung oderenergie durch einen Zusatzsensor erzeugt und/oder repräsentiert wird oder daß der Hauptsignalraum durch vektorielle Summation von Strahlungsfächern gebildet wird.

**9.** Verfahren nach einem der vorhergehenden Ansprüche, **dadurch gekennzeichnet, daß** die in Schritt f) und g) gebildeten Maße in Schritt h) gewichtet oder ungewichtet addiert oder multipliziert werden.

**10.** Verfahren nach einem der vorhergehenden Ansprüche, **dadurch gekennzeichnet, daß** der Hauptsignalraum in Unter-Signalräume unterteilt wird.

**11.** Verfahren nach einem der vorhergehenden Ansprüche, **dadurch gekennzeichnet, daß** die einfallende Empfangsleistung oder -energie zeitkontinuierlich oder zeitdiskret bestimmt wird und/oder daß das Verfahren in Echtzeit arbeitet.

**12.** Verfahren nach einem der vorhergehenden Ansprüche, **dadurch gekennzeichnet, daß** wenigstens zwei Hauptsignalräume gebildet werden.

**13.** Verfahren nach Anspruch 12, **dadurch gekennzeichnet, daß** die Hauptsignalräume redundant oder nicht redundant und/oder komplementär oder nicht komplementär sind.

**14.** Verfahren nach einem der Ansprüche 5 bis 13, **dadurch gekennzeichnet, daß** durch Bestimmung der aus dem Beobachtungsgebiet herrührenden Empfangsleistung oder -energie die Position eines Objektes im Raum festgestellt wird.

**15.** Verfahren nach einem der Ansprüche 5 bis 14, **dadurch gekennzeichnet, daß** durch gleichzeitige Wahl mehrerer Beobachtungsgebiete gleichzeitig die Position mehrerer Objekte festgestellt wird.

**16.** Verfahren nach einem der vorhergehenden Ansprüche, **dadurch gekennzeichnet, daß** durch aufeinanderfolgend unterschiedliche Wahl der Beobachtungsrichtung oder des Beobachtungsraumes oder durch gleichzeitige Wahl mehrerer Beobachtungsrichtungen oder Beobachtungsräume wenigstens ein Objekt wenigstens teilweise abgetastet wird.

**17.** Verfahren nach Anspruch 16, **dadurch gekennzeichnet, daß** aus der durch Abtasten des Objektes bzw. der Objekte bestimmten Energie- oder Leistungsverteilung des Objektes bzw. der Objekte ein Abbild des Objektes bzw. der Objekte gebildet wird.

**18.** Verfahren nach einem der vorhergehenden Ansprüche, **dadurch gekennzeichnet, daß** die Position wenigstens eines ortsfesten und/oder die Position wenigstens eines beweglichen Objektes festgestellt wird.

**19.** Verfahren nach einem der vorhergehenden Ansprüche, **dadurch gekennzeichnet, daß** durch aufeinanderfolgend unterschiedliche Wahl der Beobachtungsrichtung oder des Beobachtungsgebietes die Position eines beweglichen Objektes verfolgt wird.

**20.** Verfahren nach einem der vorhergehenden Ansprüche, **dadurch gekennzeichnet, daß** das Signal, dessen Empfangsleistung oder -energie bestimmt wird, ein radiometrisches oder ein von einem Objekt passiv und/oder aktiv emittiertes bzw. reflektiertes Signal ist.

**21.** Verfahren nach einem der vorhergehenden Ansprüche, **dadurch gekennzeichnet, daß** die aus Absorption eines sich in einer Beobachtungsrichtung und/oder einem Beobachtungsgebiet befindenden Objektes resultierende Empfangsleistung oder -energie bestimmt wird.

**22.** Verfahren nach einem der vorhergehenden Ansprüche, **dadurch gekennzeichnet, daß** die Empfangsleistung oder - energie eines Signales als Maß für die Absorption dieses Signales durch ein sich in Beobachtungsrichtung oder einem Beobachtungsgebiet befindendes Objekt bestimmt wird.

**23.** Verfahren nach einem der vorhergehenden Ansprüche, **dadurch gekennzeichnet, daß** die Strahlungsfächer durch Strahlformungsmittel erzeugt werden.

**24.** Verfahren nach einem der vorhergehenden Ansprüche, **dadurch gekennzeichnet, daß** die Sensormittel eine nicht gefüllte Apertur aufweisen, insbesondere durch wenigstens zwei Sensorzeilen, die jeweils zeilenförmig angeordnete Sensoren aufweisen, gebildet sind.

**25.** Verfahren nach Anspruch 24, **dadurch gekennzeichnet, daß** ein Schnittgebiet jeweils durch wenigstens einen Strahlungsfächer, der der ersten Sensorzeile zugeordnet ist, und wenigstens einen Strahlungsfächer, der der zweiten Sensorzeile zugeordnet ist, gebildet wird.

**26.** Verfahren nach einem der vorhergehenden Ansprüche, **dadurch gekennzeichnet, daß** das Signal, dessen einfallende Empfangsleistung oder -energie bestimmt wird, durch an einer Meteoritenspur wenigstens eines sich in der Erdatmosphäre bewegenden Meteoriten reflektierte und/oder gebeugte Radiowellen gebildet ist.

**27.** Verfahren nach einem der vorhergehenden Ansprüche, **dadurch gekennzeichnet, daß** durch gleichzeitige Wahl von wenigstens zwei Beobachtungsrichtungen oder Beobachtungsgebieten gleichzeitig wenigstens zwei von den Meteoritenspuren unterschiedlicher Meteoriten reflektierte Signale empfangen werden.

**28.** Verfahren nach einem der vorhergehenden Ansprüche, **dadurch gekennzeichnet, daß** die Strahlungsfächer, aus denen der Hauptsignalraum gebildet wird, fest vorgegeben oder wählbar sind.

**29.** Verfahren nach einem der Ansprüche 24 bis 28, **dadurch gekennzeichnet, daß** jeder einer Sensorzeile zugeordnete Strahlungsfächer mit einem diesem Strahlungsfächer zugeordneten Hauptsignalraum und mit jedem einer anderen Sensorzeile zugeordneten Strahlungsfächer korrelierbar ist.

**30.** Verfahren nach einem der Ansprüche 12 bis 29, **dadurch gekennzeichnet, daß** in Bezug auf ein ausgewähltes Schnittgebiet
- durch Korrelation der an der Bildung des Schnittgebietes beteiligten Strahlungsfächer ein erstes Korrelationsergebnis gebildet wird,
- durch Korrelation eines an der Bildung des Schnittgebietes beteiligten Strahlungsfächers mit einem diesem Strahlungsfächer zugeordneten ersten Hauptsignalraum ein zweites Korrelationsergebnis gebildet wird,
- durch Korrelation eines an der Bildung des Schnittgebietes beteiligten anderen Strahlungsfächers mit einem diesem Strahlungfächer zugeordneten weiteren Hauptsignalraum ein drittes Korrelationsergebnis gebildet wird,
- das erste Korrelationsergebnis mit dem zweiten Korrelationsergebnis zu einem ersten Zwischenergebnis, vorzugsweise durch Multiplikation, verknüpft wird,
- das dritte Korrelationsergebnis mit dem ersten Korrelationsergebnis zu einem zweiten Zwischenergebnis, vorzugsweise durch Multiplikation, verknüpft wird, und
- das erste Zwischenergebnis und das zweite Zwischenergebnis zur Bildung des Maßes gemäß Schritt h), vorzugweise durch Addition, verknüpft werden.

**31.** Vorrichtung zur Bestimmung einfallender Empfangsleistung oder -energie oder anderer technischer Meßgrößen wenigstens eines Signales in wenigstens einer vorgebbaren Beobachtungsrichtung, insbesondere zur Durchführung des Verfahrens nach einem der Ansprüche 1 bis 30,
mit Sensormitteln (125, 126) zur Erfassung wenigstens eines Signales,
mit Strahlformungsmitteln (128) zum Bilden von Strahlungsfächern (42) aus Ausgangssignalen einzelner Sensoren, Gruppen von Sensoren oder Sensorbereichen der Sensormittel (126), wobei wenigstens zwei Strahlungsfächer (42) wenigstens ein Schnittgebiet (45) bilden,
mit Mitteln (131) zur Bildung wenigstens eines Hauptsignalraumes (43), der die Form einer Anzahl von Strahlungsfächern (42) und die diesen Strahlungsfächern (42) zugeordnete Empfangsleistung oder -energie repräsentiert,
mit Auswahlmitteln zur Auswahl wenigstens eines Schnittgebietes (45) zur Auswahl wenigstens einer Beobachtungsrichtung,
mit Auswertemitteln (130, 131, 132) zur Bestimmung eines ersten Maßes für den Anteil jedes an der Bildung des ausgewählten Schnittgebietes (45) beteiligten Strahlungsfächers (42) an der dem Hauptsignalraum zugeordneten Gesamtempfangsleistung oder -energie und zur Bestimmung eines zweiten Maßes für den Anteil des ausgewählten Schnittgebietes (45) an der Empfangsleistung oder -energie, die den an der Bildung des Schnittgebietes (45) beteiligten Strahlungsfächern (42) zugeordnet ist, und
mit Verknüpfungsmitteln (135) zur Verknüpfung des durch die Auswertemittel (130, 131, 132) bestimmten ersten Maßes mit dem durch die Auswertemittel (130, 131, 132) bestimmten zweiten Maß.

**32.** Vorrichtung nach Anspruch 31, **dadurch gekennzeichnet, daß** die Auswertemittel (130, 131, 132) wenigstens einen Korrelator (132) zur Bestimmung des ersten Maßes jeweils durch Korrelation der betreffenden Strahlungsfächer (42) mit dem zugeordneten Hauptsignalraum (43) und/oder wenigstens einen Korrelator (130) zur Bestimmung des zweiten Maßes durch Korrelation der an der Bildung des Schnittgebietes (45) beteiligten Strahlungsfächer (42) miteinander aufweisen.

**33.** Vorrichtung nach Anspruch 31 oder 32, **dadurch gekennzeichnet, daß** die Auswahlmittel zur gleichzeitigen Auswahl von wenigstens zwei Schnittgebieten (45) ausgebildet sind.

**34.** Vorrichtung nach einem der Ansprüche 31 bis 33, **gekennzeichnet durch** Mittel (133) zur Bestimmung der dem Hauptsignalraum (43) zugeordneten Gesamtempfangsleistung oder -energie oder der einem Strahlungsfächer (42) zugeordneten Empfangsleistung oder -energie.

**35.** Vorrichtung nach einem der Ansprüche 31 bis 34, **dadurch gekennzeichnet, daß** die Mittel zur Bildung wenigstens eines Hauptsignalraumes (43) Mittel zur analogen oder digitalen vektoriellen Summation von Strahlungsfächern (42) und/oder einen Zusatzsensor aufweisen.

**36.** Vorrichtung nach einem der Ansprüche 31 bis 35, **dadurch gekennzeichnet, daß** die Verknüpfungsmittel (135) wenigstens eine Multipliziereinrichtung (135a) und/oder wenigstens eine Addiereinrichtung (135b) zur gewichteten oder ungewichteten Multiplikation und/oder Addition insbesondere des ersten Maßes mit dem zweiten Maß aufweisen.

**37.** Vorrichtung nach einem der Ansprüche 31 bis 36, **dadurch gekennzeichnet, daß** die Sensormittel (125, 126) wenigstens zwei Sensorzeilen (125, 126) aufweisen, die jeweils zeilenförmig angeordnete Sensoren aufweisen.

**38.** Vorrichtung nach einem der Ansprüche 31 bis 37, **dadurch gekennzeichnet, daß** die Sensoren durch akustische Sensoren und/oder Sensoren zur Detektion von Wärmestrahlung und/oder Sensoren zur Detektion von elektromagnetischer Strahlung, insbesondere durch Antennen, vorzugsweise durch Dipole, gebildet sind.

**39.** Vorrichtung Anspruch 37 oder 38, **dadurch gekennzeichnet, daß** die Sensorzeilen (125, 126) jeweils dieselbe Anzahl von Sensoren aufweisen.

**40.** Vorrichtung nach einem der Ansprüche 37 bis 39, **dadurch gekennzeichnet, daß** die Strahlformungsmittel wenigstens zwei Strahlformungseinrichtungen (128) aufweisen, die jeweils einer Sensorzeile (125, 126) zugeordnet sind und die aus den Ausgangssignalen der jeweiligen Sensorzeile (125, 126) eine vorgebbare Anzahl von Strahlungsfächern (42) bilden.

**41.** Vorrichtung nach Anspruch 40, **dadurch gekennzeichnet, daß** die Strahlformungseinrichtungen jeweils durch eine analog oder digital arbeitende Butler-Matrix (128) gebildet sind.

**42.** Vorrichtung nach 40 oder 41, **dadurch gekennzeichnet, daß** den Ausgängen jeder Strahlformungseinrichtung (128) wenigstens eine Quantisiereinrichtung (129e) nachgeordnet ist, die das einem Ausgang der Strahlformungseinrichtung (128) zugeordnete, einen Strahlungsfächer (42) repräsentierende Signal quantisiert, vorzugsweise mit reduzierter Quantisierung, insbesondere 1-bit-wertig, quantisiert.

**43.** Vorrichtung nach ein der Anspruch 42, **dadurch gekennzeichnet, daß** jedem Ausgang der Strahlformungseinrichtung (128) eine Quantisiereinrichtung (129e) nachgeordnet ist.

**44.** Vorrichtung nach einem der Ansprüche 32 bis 43, **dadurch gekennzeichnet, daß** jeweils einem Ausgang der Strahlformungseinrichtung (128) ein Korrelator (132) zur Korrelation des durch das Ausgangssignal dieses Ausganges repräsentierten Strahlungsfächers (42) mit einem zugeordneten Hauptsignalraum (43) und/oder ein Korrelator (130) zur Korrelation des betreffenden Strahlungsfächers (42) mit einem anderen Strahlungsfächer (42), der durch das Ausgangssignal einer anderen Strahlformungseinrichtung repräsentiert ist, nachgeordnet ist.

**46.** Vorrichtung nach einem der Ansprüche 31 bis 45, **dadurch gekennzeichnet, daß** die Verknüpfungsmittel (135) in Bezug auf ein ausgewähltes Schnittgebiet (45) wenigstens
- ein erstes, durch Korrelation der an der Bildung des Schnittgebietes (45) beteiligten Strahlungsfächer (42) erhaltenes Korrelationsergebnis und/oder
- ein zweites, durch Korrelation eines an der Bildung des Schnittgebietes (45) beteiligten Strahlungsfächers (42) mit einem diesem Strahlungsfächer (42) zugeordneten ersten Hauptsignalraum (43) erhaltenes Korrelationsergebnis und/oder
- ein drittes, durch Korrelation eines an der Bildung des Schnittgebietes (45) beteiligten anderen Strahlungsfächers (42) mit einem diesem Strahlungfächer (42) zugeordneten weiteren Hauptsignalraum (43) erhaltenes Korrelationsergebnis
miteinander verknüpfen.

**47.** Vorrichtung nach Anspruch 46, **dadurch gekennzeichnet, daß** die Verknüpfungsmittel (135) in bezug auf das ausgewählte Schnittgebiet (43)
- das erste Korrelationsergebnis mit dem zweiten Korrelationsergebnis zu einem ersten Zwischenergebnis, vorzugsweise durch Multiplikation, verknüpfen,
- das dritte Korrelationsergebnis mit dem ersten Korrelationsergebnis zu einem zweiten Zwischenergebnis, vorzugsweise durch Multiplikation, verknüpfen und
- das erste Zwischenergebnis und das zweite zwischenergebnis, vorzugweise durch Addition, verknüpfen.

**48.** Empfangsanlage zum Empfang von Signalen, **dadurch gekennzeichnet, daß** sie Mittel zur Durchführung eines Verfahrens nach einem der Ansprüche 1 bis 30 aufweist und/oder mit einer Vorrichtung nach einem der Ansprüche 31 bis 47 versehen ist.

## Claims

**1.** A method for determining incident received power or energy or other technical measurement values of at least one signal in at least one predeterminable direction of observation, comprising the following method stages:
(a) detecting an incident signal using sensors,
(b) forming fan beams associated to individual sensors, sets of sensors or sensor zones of the sensors,
(c) forming at least one intersection zone of at least two fan beams,
(d) forming at least one main signal space evincing the configuration of a number of fan beams and representing the received power or energy associated to these fan beams,
(e) selecting at least one intersection zone,
(f) for each fan beam participating in the formation of the selected intersection zone, determining a measure for the portion of the total received power or energy associated to the main signal space,
(g) determining a measure for the portion associated with the selected intersection zone of the received power or energy relating to the fan beams participating in forming the intersection zone, and
(h) combining the measurements carried out in steps (f) and (g) to form a measure for the portion of received power or energy incident in the predetermined direction of observation of the total received power or energy associated with the main signal space.

**2.** Method as claimed in claim 1, **characterized in that** the measure for the portion of each fan beam participating in forming an intersection zone of the total power or energy associated with the main signal space is determined by correlating the particular fan beam with the main signal space.

**3.** Method as claimed in either of claims 1 and 2, **characterized in that** the measure for the portion associated with the selected intersection zone of the received power or energy associated with the fan beams forming said intersection zone is obtained by correlating the fan beams participating in forming the intersection zone.

**4.** Method as claimed in one of the above claims, **characterized in that** the fan beams form at least two, preferably more than two intersection zones in such manner that different directions of observation can be selected by selecting different intersection zones.

**5.** Method as claimed in one of the above claims, **characterized in that** at least three fan beams form a spatial intersection zone constituting a region of observation in such manner that the received power or energy from the region of observation can be determined.

**6.** Method as claimed in one of the above claims, **characterized in that** the incident received power or energy is determined simultaneously in at least two directions of observation and/or for at least two regions of observation.

**7.** Method as claimed in one of the above claims, **characterized by** determining the total received power or energy associated with the main signal space or a measure of this total received power or energy.

**8.** Method as claimed in one of the above claims, **characterized in that** the main signal space is generated and/or represented according to the shape of fan beams and the received power or energy associated with these fan beams or **in that** the main signal space is formed by vectorially summing fan beams.

**9.** Method as claimed in one of the above claims, **characterized in that** the measures formed in steps (f) and (g) in step (h) are added or multiplied in weighted or unweighted form.

**10.** Method as claimed in one of the above claims, **characterized in that** the main signal space is sub-divided into signal sub-spaces.

**11.** Method as claimed in one of the above claims, **characterized in that** the incident received power or energy is determined in continuous or discrete time and/or **in that** the method is implemented in real time.

**12.** Method as claimed in one of the above claims, **characterized in that** at least two main signal spaces are formed.

**13.** Method as claimed in claim 12, **characterized in that** the main signal spaces are redundant or non-redundant and/or complementary or non-complementary.

**14.** Method as claimed in one of claims 5 through 13, **characterized in that** the spatial position of an object is determined by ascertaining the received power or energy from the region of observation.

**15.** Method as claimed in one of claims 5 through 14, **characterized in that** the positions of several objects are determined simultaneously by simultaneously selecting several regions of observation.

**16.** Method as claimed by one of the above claims, **characterized in that** at least one object is at least partly scanned by a consecutively different selection of the direction of observation or the region of observation or by simultaneously selecting several directions of observation or regions of observation.

**17.** Method as claimed in claim 16, **characterized in that** the energy or power distribution of the object(s) determined by scanning the object(s) is used to image the object(s).

**18.** Method as claimed in one of the above claims, **characterized in that** the position of at least one stationary object and/or the position of at least one movable object is determined.

**19.** Method as claimed in one of the above claims, **characterized in that** the position of a movable object is monitored by the consecutively different selection of the direction of observation or the region of observation.

**20.** Method as claimed in one of the above claims, **characterized in that** the signal of which the received power or energy is being determined consists of a radiometric signal or a signal which is passively and/or actively emitted or reflected by an object.

**21.** Method as claimed in one of the above claims, **characterized in** determining the received power or energy resulting from the absorption by an object present in a direction of observation and/or a region of observation.

**22.** Method as claimed in one of the above claims, **characterized in that** the received power or energy of a signal is determined as a measure of the absorption of this signal by an object present in the direction of observation or in a region of observation.

**23.** Method as claimed in one of the above claims, **characterized in that** the fan beams are generated by beam shaping means.

**24.** Method as claimed in one of the above claims, **characterized in that** the sensors evince an unfilled aperture, in particular composed of at least two rows of sensors, each with sensors in a row.

**25.** Method as claimed in claim 24, **characterized in that** an intersection zone consists of at least one fan beam associated with the first row of sensors and at least one fan beam associated with the second row of sensors.

**26.** Method as claimed in one of the above claims, **characterized in that** the signal of which the incident received power or energy is being determined is formed by radio waves reflected and/or diffracted by a meteorite trail of at least one meteorite moving in the earth atmosphere.

**27.** Method as claimed in one of the above claims, **characterized in that** by simultaneously selecting at least two directions of observation or regions of observation, at least two signals reflected by the meteorite trails of different meteorites are received simultaneously.

**28.** Method as claimed in one of the above claims, **characterized in that** the fan beams forming the main signal space are rigorously predeterminable or selectable.

**29.** Method as claimed in one of claims 24 through 28, **characterized in that** each fan beam associated with a row of sensors can be correlated with a main signal space associated with said fan beam and with each fan beam associated with another row of sensors.

**30.** Method as claimed in one of claims 12 through 29, **characterized in that**, as regards a selected intersection zone:
-- a first correlation result is formed by correlating the fan beams participating in the formation of the intersection zone,
-- a second correlation result is formed by correlating a fan beam participating in the formation of the intersection zone with a first main signal space associated with said fan beam,
-- a third correlation result is formed by correlating another fan beam participating in the formation of the intersection zone with a further main signal space associated to said fan beam,
-- the first correlation result is combined preferably by multiplication with the second correlation result into a first interim result,
-- the third correlation result is combined, preferably by multiplication, with the first correlation result into a second interim result, and
-- the first interim result and the second interim result are combined preferably by addition, to form the measure defined in step (h).

**31.** Apparatus for determining incident power or energy or other technical measurement values of a signal in at least one predeterminable direction of observation, in particular to carry out the method claimed in one of claims 1 through 30,
comprising sensor systems (125, 126) to detect at least one signal,
comprising beam shaping means (128) to form fan beams (42) from output signals of individual sensors or sensor zones of the sensor systems (126), at least two fan beams (42) forming one intersection zone (45),
comprising means (131) to form at least one main signal space (43) representing the shape of a number of fan beams (42) and the received power or energy associated with said fan beams (42),
comprising selection means to select at least one intersection zone (45) to select at least one direction of observation (direction of measurement),
comprising analyzers (130, 131, 132) to determine a first measure of the portion of each fan beam (42) participating in the formation of the selected intersection zone (45) of the total received power or energy associated with the main signal space and to determine a second measure for the portion of the selected intersection zone (45) of the received power or energy associated with the fan beams (42) participating in the formation of the intersection zone (45), and
comprising combination means (135) to chain the first measure determined by the analyzers (130, 131, 132) with the second measure determined by the analyzers (130, 131, 132).

**32.** Apparatus as claimed in claim 31, **characterized in that** the analyzers (130, 131, 132) comprise at least one correlator (132) to determine the first measure by correlating the particular fan beam (42) with the associated main signal space (43) and/or at least one correlator (130) to determine the second measure by correlating with each other the fan beams (42) participating in the formation of the intersection zone (45).

**33.** Apparatus as claimed in either of claims 31 and 32, **characterized in that** the selection means are designed to simultaneously select at least two intersection zones (45).

**34.** Apparatus as claimed in one of claims 31 through 33, **characterized by** means (133) to determine the total received power or energy associated with the main signal space (43) or to determine the received power or energy associated with one fan beam (42).

**35.** Apparatus as claimed in one of claims 31 through 34, **characterized in that** the means forming at least one main signal space (43) comprise devices for vectorially summing, in analog or digital manner, fan beams (42) and/or at least one additional sensor.

**36.** Apparatus as claimed in one of claims 31 through 35, **characterized in that** the combination means (135) comprise at least one multiplier (135a) and/or at least one adder (135b) for the weighted or unweighted multiplication and/or addition in particular of the first measure by and/or to the second measure.

**37.** Apparatus as claimed in one of claims 31 through 36, **characterized in that** the sensor systems (125, 126) comprise at least two rows of sensors (125, 126) each evincing sensors in a row.

**38.** Apparatus as claimed in one of claims 31 through 37, **characterized in that** the sensors are acoustic sensors and/or sensor detecting heat radiation and/or sensors detecting electromagnetic radiation, in particular being antennas, preferably dipoles.

**39.** Apparatus as claimed in either of claims 37 and 38, **characterized in that** the sensor rows (125, 126) each comprise the same number of sensors.

**40.** Apparatus as claimed in one of claims 37 through 39, **characterized in that** the beam shaping means comprise at least two beam-shaping devices (128) each associated to a row (125, 126) of sensors and forming a predeterminable number of fan beams (42) from the output signals of the particular row (125, 126) of sensors.

**41.** Apparatus as claimed in claim 40, **characterized in that** the beam-shaping devices each consist of a Butler matrix (128) operating in analog or digital manner.

**42.** Apparatus as claimed in either of claims 40 and 41, **characterized in that** at least one quantizing device (129e) is placed after the outputs of each beam-shaping device (128) and quantizes the signal representing a fan beam (42) associated to an output of the beam-shaping device (129e), preferably at reduced quantization, especially at 1-bit values.

**43.** Apparatus as claimed in claim 42, **characterized in that** each output of the beam-shaping device (128) is followed by an associated quantizing device (129e).

**44.** Apparatus as claimed in one of claims 32 through 43, **characterized in that** each output of the beam-shaping device (128) is followed by a correlator (132) to correlate the fan beam (42) representing said output with an associated main signal space (43) and/or a correlator (130) to correlate the particular fan beam (42) with another fan beam (42) represented by the output signal from another beam-shaping device.

**46.** Apparatus as claimed in one of claims 31 through 44, **characterized in that**, as regards a selected intersection zone (45), the combination means (135) chain together at least
-- a first correlation result obtained by correlating the fan beams (42) participating in the formation of the intersection zone (45) and/or
-- a second correlation result obtained by correlating a fan beam (42) participating in the formation of the intersection zone (45) with a first main signal space (43) associated to this fan beam (42), and/or
-- a third correlation result obtained by correlating another fan beam (42) participating in the formation of the intersection zone (45) with a further main signal space (43) associated to this fan beam (42).

**47.** Apparatus as claimed in claim 46 **characterized in that** as regards the selected intersection zone (43), the combination means (135)
-- chain, preferably by multiplication, the first correlation result with the second correlation result into a first interim result,
-- chain, preferably by multiplication, the third correlation result with the first correlation result into a second interim result, and
-- chain, preferably by addition, the first interim result and the second interim result.

**48.** Receiving equipment to receive signals, **characterized in that** it includes means for carrying out the method of one of the claims 1 through 30 and/or that it is equipped with apparatus as claimed in one of claims 31 through 47.

## Revendications

**1.** Procédé pour déterminer la puissance ou l'énergie de réception arrivant ou d'autres grandeurs de mesure technique d'au moins un signal dans au moins une direction d'observation prédéfinissable, comprenant les étapes de procédé suivantes :
a) enregistrement d'un signal arrivant à l'aide de moyens de détection,
b) formation d'éventails de rayonnement, attribués à des capteurs individuels, des groupes de capteurs ou zones de détection des moyens de détection,
c) formation d'au moins une zone de coupe entre au moins deux éventails de rayonnement,
d) formation d'au moins un espace de signal principal, qui représente la forme d'un certain nombre d'éventails de rayonnement et la puissance ou l'énergie de réception attribuée à ces éventails de rayonnement,
e) sélection d'au moins une zone de coupe
f) détermination d'une référence pour la fraction de chaque éventail de rayonnement impliqué dans la formation de la zone de coupe choisie par rapport à la puissance ou l'énergie de réception globale attribuée à l'espace de signal principal,
g) détermination d'une référence pour la fraction attribuée à la zone de coupe choisie par rapport à la puissance ou l'énergie de réception qui est attribuée aux éventails de rayonnement impliqués dans la formation de la zone de coupe et
h) association des références obtenues aux étapes f) et g) pour la formation d'une référence pour la fraction de la puissance ou de l'énergie de réception arrivant dans la direction d'observation prédéfinie par rapport à la puissance ou l'énergie de réception globale attribuée à l'espace de signal principal.

**2.** Procédé selon la revendication 1, **caractérisé en ce que** la référence pour la fraction de chaque éventail de rayonnement impliqué dans la formation d'une zone de coupe par rapport à la puissance ou l'énergie de réception globale attribuée à l'espace de signal principal est déterminée par corrélation de l'éventail concerné avec l'espace de signal principal.

**3.** Procédé selon la revendication 1 ou 2, **caractérisé en ce que** la référence pour la fraction attribuée à la zone de coupe choisie par rapport à la puissance ou l'énergie de réception, qui est attribuée aux éventails de rayonnement formant cette zone de coupe, est formée par corrélation des éventails de rayonnement impliqués dans la formation de la zone de coupe.

**4.** Procédé selon l'une quelconque des revendications précédentes, **caractérisé en ce que** les éventails de rayonnement forment au moins deux, de préférence plus de deux, zones de coupe de telle sorte que différentes directions d'observation sont éligibles par le choix de différentes zones de coupe.

**5.** Procédé selon l'une quelconque des revendications précédentes, **caractérisé en ce qu'**au moins trois éventails de rayonnement forment une zone de coupe dans l'espace qui forme une zone d'observation de telle sorte que la puissance ou l'énergie de réception provenant de la zone d'observation peut être déterminée.

**6.** Procédé selon l'une quelconque des revendications précédentes, **caractérisé en ce que** la puissance ou l'énergie de réception arrivant est déterminée en même temps dans au moins deux directions d'observation et/ ou pour au moins deux zones d'observation.

**7.** Procédé selon l'une quelconque des revendications précédentes, **caractérisé en ce que** la puissance ou l'énergie de réception globale attribuée à l'espace de signal principal, ou une référence pour cette puissance ou énergie de réception globale est déterminée.

**8.** Procédé selon l'une quelconque des revendications précédentes, **caractérisé en ce que** l'espace de signal principal est généré et/ou représenté sous la forme d'éventails de rayonnement et de la puissance ou de l'énergie de réception attribuée à ces éventails de rayonnement par un capteur supplémentaire ou **en ce que** l'espace de signal principal est formé par la sommation vectorielle d'éventails de rayonnement.

**9.** Procédé selon l'une quelconque des revendications précédentes, **caractérisé en ce que** les références formées aux étapes f) et g) sont additionnées ou multipliées de façon pondérée ou non pondérée à l'étape h).

**10.** Procédé selon l'une quelconque des revendications précédentes, **caractérisé en ce que** l'espace de signal principal est subdivisé en sous-espaces de signaux.

**11.** Procédé selon l'une quelconque des revendications précédentes, **caractérisé en ce que** la puissance ou l'énergie de réception arrivant est déterminée de façon continue ou discrète dans le temps et/ ou **en ce que** le procédé travaille en temps réel.

**12.** Procédé selon l'une quelconque des revendications précédentes, **caractérisé en ce qu'**au moins deux espaces de signal principal sont formés.

**13.** Procédé selon la revendication 12, **caractérisé en ce que** les espaces de signal principal sont redondants ou non redondants et/ou complémentaires ou non complémentaires.

**14.** Procédé selon l'une quelconque des revendications 5 à 13, **caractérisé en ce que** la position d'un objet dans l'espace est déterminée par détermination de la puissance ou de l'énergie de réception provenant de la zone d'observation.

**15.** Procédé selon l'une quelconque des revendications 5 à 14, **caractérisé en ce que** la position de plusieurs objets est déterminée en même temps par le choix simultané de plusieurs zones d'observation.

**16.** Procédé selon l'une quelconque des revendications précédentes, **caractérisé en ce qu'**au moins un objet est exploré au moins partiellement par le choix successivement différent de la direction d'observation ou de l'espace d'observation ou par le choix simultané de plusieurs directions ou espaces d'observation.

**17.** Procédé selon la revendication 16, **caractérisé en ce qu'**une représentation de l'objet ou des objets est formée à partir de la répartition d'énergie ou de puissance de l'objet ou des objets, qui est déterminée par l'exploration de l'objet ou des objets.

**18.** Procédé selon l'une quelconque des revendications précédentes, **caractérisé en ce que** la position d'au moins un objet fixe et/ou la position d'au moins un objet mobile est déterminée.

**19.** Procédé selon l'une quelconque des revendications précédentes, **caractérisé en ce que** la position d'un objet mobile est suivie par le choix successivement différent de la direction d'observation ou de la zone d'observation.

**20.** Procédé selon l'une quelconque des revendications précédentes, **caractérisé en ce que** le signal, dont la puissance ou l'énergie de réception est déterminée, est un signal radiométrique ou un signal émis ou réfléchi de façon passive et/ou active par un objet.

**21.** Procédé selon l'une quelconque des revendications précédentes, **caractérisé en ce que** la puissance ou l'énergie de réception résultant de l'absorption d'un objet se trouvant dans une direction d'observation et/ou une zone d'observation est déterminée.

**22.** Procédé selon l'une quelconque des revendications précédentes, **caractérisé en ce que** la puissance ou l'énergie de réception d'un signal est déterminée comme référence pour l'absorption de ce signal par un objet se trouvant dans la direction d'observation ou une zone d'observation.

**23.** Procédé selon l'une quelconque des revendications précédentes, **caractérisé en ce que** les éventails de rayonnement sont générés par des moyens de mise en forme de faisceau.

**24.** Procédé selon l'une quelconque des revendications précédentes, **caractérisé en ce que** les moyens de détection présentent une ouverture non remplie, en particulier par au moins deux rangées de capteurs, qui présentent chacune des capteurs disposés en forme de rangée.

**25.** Procédé selon la revendication 24, **caractérisé en ce qu'**une zone de coupe est formée par au moins un éventail de rayonnement, qui est attribué à la première rangée de capteurs, et au moins un éventail de rayonnement qui est attribué à la deuxième rangée de capteurs.

**26.** Procédé selon l'une quelconque des revendications précédentes, **caractérisé en ce que** le signal, dont la puissance ou l'énergie de réception arrivant est déterminée, est formé par des ondes radio réfléchies et/ou diffractées sur une trace de météorite d'au moins une météorite se déplaçant dans l'atmosphère terrestre.

**27.** Procédé selon l'une quelconque des revendications précédentes, **caractérisé en ce que**, par le choix simultané d'au moins deux directions ou zones d'observation, au moins deux signaux réfléchis par les traces de météorite de différentes météorites sont reçus en même temps.

**28.** Procédé selon l'une quelconque des revendications précédentes, **caractérisé en ce que** les éventails de rayonnement, à partir desquels l'espace de signal principal est formé, sont prédéfinis de façon fixe ou éligibles.

**29.** Procédé selon l'une quelconque des revendications 24 à 28, **caractérisé en ce que** chaque éventail de rayonnement attribué à une rangée de capteurs peut être mis en corrélation avec un espace de signal principal attribué à cet éventail de rayonnement et avec chaque éventail de rayonnement attribué à une autre rangée de capteurs.

**30.** Procédé selon l'une quelconque des revendications 12 à 29, **caractérisé en ce que**, par rapport à une zone de coupe choisie,
- un premier résultat de corrélation est formé par la corrélation des éventails de rayonnement impliqués dans la formation de la zone de coupe,
- un deuxième résultat de corrélation est formé par la corrélation d'un éventail de rayonnement impliqué dans la formation de la zone de coupe avec un premier espace de signal principal attribué à cet éventail de rayonnement,
- un troisième résultat de corrélation est formé par la corrélation d'un autre éventail de rayonnement impliqué dans la formation de la zone de coupe avec un autre espace de signal principal attribué à cet éventail de rayonnement,
- le premier résultat de corrélation est associé au deuxième résultat de corrélation pour obtenir un premier résultat intermédiaire, de préférence par multiplication,
- le troisième résultat de corrélation est associé avec le premier résultat de corrélation pour obtenir un deuxième résultat intermédiaire, de préférence par multiplication, et
- le premier résultat intermédiaire et le deuxième résultat intermédiaire sont associés pour former la référence selon l'étape h), de préférence par addition.

**31.** Dispositif pour déterminer la puissance ou l'énergie de réception arrivant ou d'autres grandeurs de mesure techniques d'au moins un signal dans au moins une direction d'observation prédéfinissable, en particulier pour la mise en oeuvre du procédé selon l'une quelconque des revendications 1 à 30, comprenant :
des moyens de détection (125, 126) pour l'enregistrement d'au moins un signal,
des moyens de mise en forme de faisceau (128) pour la formation d'éventails de rayonnement (42) à partir de signaux de départ de capteurs individuels, de groupes de capteurs ou de zones de détection des moyens de détection (126), au moins deux éventails de rayonnement (42) formant au moins une zone de coupe (45),
des moyens (131) pour la formation d'au moins un espace de signal principal (43), qui représente la forme d'un certain nombre d'éventails de rayonnement (42) et la puissance ou l'énergie de réception attribuée à ces éventails de rayonnement (42),
des moyens de sélection pour la sélection d'au moins une zone de coupe (45) pour la sélection d'au moins une direction d'observation,
des moyens d'analyse (130, 131, 132) pour la détermination d'une première référence pour la fraction de chaque éventail de rayonnement (42) impliqué dans la formation de la zone de coupe (45) choisie, par rapport à la puissance ou l'énergie de réception globale attribuée à l'espace de signal principal, et pour la détermination d'une deuxième référence pour la fraction de la zone de coupe (45) choisie par rapport à la puissance ou l'énergie de réception qui est attribuée aux éventails de rayonnement (42) impliqués dans la formation de la zone de coupe (45) et
des moyens d'association (135) pour l'association de la première référence déterminée par les moyens d'analyse (130, 131, 132) avec la deuxième référence déterminée par les moyens d'analyse (130, 131, 132).

**32.** Dispositif selon la revendication 31, **caractérisé en ce que** les moyens d'analyse (130, 131, 132) comportent ensemble au moins un corrélateur (132) pour la détermination de la première référence respectivement par la corrélation des éventails de rayonnement (42) concernés avec l'espace de signal principal (43) attribué, et/ou au moins un corrélateur (130) pour la détermination de la deuxième référence par corrélation des éventails de rayonnement (42) impliqués dans la formation de la zone de coupe (45).

**33.** Dispositif selon la revendication 31 ou 32, **caractérisé en ce que** les moyens de sélection sont formés pour le choix simultané d'au moins deux zones de coupe (45).

**34.** Dispositif selon l'une quelconque des revendications 31 à 33, **caractérisé par** des moyens (133) pour la détermination de la puissance ou de l'énergie de réception globale attribuée à l'espace de signal principal (43), ou de la puissance ou de l'énergie de réception attribuée à un éventail de rayonnement (42).

**35.** Dispositif selon l'une quelconque des revendications 31 à 34, **caractérisé en ce que** les moyens pour la formation d'au moins un espace de signal principal (43) présentent des moyens pour la sommation vectorielle analogique ou numérique d'éventails de rayonnement (42) et/ou un capteur supplémentaire.

**36.** Dispositif selon l'une quelconque des revendications 31 à 35, **caractérisé en ce que** les moyens d'association (135) présentent au moins un dispositif de multiplication (135a) et/ou au moins un dispositif d'addition (135b) pour la multiplication et/ou l'addition pondérée ou non pondérée en particulier de la première référence avec la deuxième référence.

**37.** Dispositif selon l'une quelconque des revendications 31 à 36, **caractérisé en ce que** les moyens de détection (125, 126) présentent au moins deux rangées de capteurs (125, 126), qui présentent chacune des capteurs disposés en forme de rangée.

**38.** Dispositif selon l'une quelconque des revendications 31 à 37, **caractérisé en ce que** les capteurs sont formés par des capteurs acoustiques et/ou des capteurs pour la détection de rayonnement de chaleur et/ou des capteurs pour la détection de rayonnement électromagnétique, en particulier par des antennes, de préférence par des dipôles.

**39.** Dispositif selon la revendication 37 ou 38, **caractérisé en ce que** les rangées de capteurs (125, 126) présentent chacune le même nombre de capteurs.

**40.** Dispositif selon l'une quelconque des revendications 37 à 39, **caractérisé en ce que** les moyens de mise en forme de faisceau présentent au moins deux dispositifs de mise en forme de faisceau (128), qui sont attribués chacun à une rangée de capteurs (125, 126) et qui forment à partir des signaux de sortie de chaque rangée de capteurs (125, 126) un nombre prédéfinissable d'éventails de rayonnement (42).

**41.** Dispositif selon la revendication 40, **caractérisé en ce que** les dispositifs de mise en forme de faisceau sont formés chacun par une matrice de Butler (128) travaillant de façon analogique ou numérique.

**42.** Dispositif selon la revendication 40 ou 41, **caractérisé en ce que**, en aval des sorties de chaque dispositif de mise en forme de faisceau (128), est disposé au moins un dispositif de quantification (129e) qui quantifie le signal attribué à une sortie du dispositif de mise en forme de faisceau (128) et représentant un éventail de rayonnement (42), de préférence avec une quantification réduite, en particulier d'une valeur de bit 1.

**43.** Dispositif selon la revendication 42, **caractérisé en ce qu'**un dispositif de quantification (129e) est placé en aval de chaque sortie du dispositif de mise en forme de faisceau (128).

**44.** Dispositif selon l'une quelconque des revendications 32 à 43, **caractérisé en ce que**, en aval de chaque sortie du dispositif de mise en forme de faisceau (128), est placé un corrélateur (132) pour la corrélation de l'éventail de rayonnement (42) représenté par le signal de sortie de cette sortie avec un espace de signal principal (43) attribué, et/ou un corrélateur (130) pour la corrélation de l'éventail de rayonnement (42) concerné avec un autre éventail de rayonnement (42) qui est représenté par le signal de sortie d'un autre dispositif de mise en forme de faisceau.

**46.** Dispositif selon l'une quelconque des revendications 31 à 45, **caractérisé en ce que** les moyens d'association (135) associent les uns avec les autres, par rapport à une zone de coupe (45) sélectionnée, au moins
- un premier résultat de corrélation obtenu par la corrélation des éventails de rayonnement (42) impliqués dans la formation de la zone de coupe (45) et/ou
- un deuxième résultat de corrélation obtenu par la corrélation d'un éventail de rayonnement (42) impliqué dans la formation de la zone de coupe (45) avec un premier espace de signal principal (43) attribué à cet éventail de rayonnement (42) et/ou
- un troisième résultat de corrélation obtenu par la corrélation d'un autre éventail de rayonnement (42) impliqué dans la formation de la zone de coupe (45) avec un autre espace de signal principal (43) attribué à cet éventail de rayonnement (42).

**47.** Dispositif selon la revendication (46), **caractérisé en ce que**, par rapport à la zone de coupe (43) sélectionnée, les moyens d'association (135)
- associent, de préférence par multiplication, le premier résultat de corrélation avec le deuxième résultat de corrélation pour former un premier résultat intermédiaire,
- associent, de préférence par multiplication, le troisième résultat de corrélation avec le premier résultat de corrélation pour former un deuxième résultat intermédiaire, et
- associent, de préférence par addition, le premier résultat intermédiaire et le deuxième résultat intermédiaire.

**48.** Installation de réception pour la réception de signaux, **caractérisée en ce qu'**elle présente des moyens pour la mise en oeuvre d'un procédé selon l'une quelconque des revendications 1 à 30 et/ou est dotée d'un dispositif selon l'une quelconque des revendications 31 à 47.
